# EUROPÄISCHE PATENTSCHRIFT

(11) **EP 0 436 675 B1**
(45) Veröffentlichungstag und Bekanntmachung des Hinweises auf die Patenterteilung: **02.06.1993**
(21) Anmeldenummer: 90904239.2
(22) Anmeldetag: 16.03.1990
(51) Int. Cl.: G01V 3/14, G01R 33/44, G01R 33/48

(54) **VERFAHREN UND VORRICHTUNG ZUM ORTEN VON UNTERSEEBOOTE**
PROCESS AND DEVICE FOR LOCATING SUBMARINES
PROCEDE ET DISPOSITIF DE LOCALISATION DE SOUS-MARINS

(30) Priorität: 16.03.1989 DE 3908576
(43) Veröffentlichungstag der Anmeldung: 17.07.1991
(73) Patentinhaber: LAUKIEN, Günther, D-76287 Rheinstetten (DE)
(72) Erfinder: LAUKIEN, Günther, D-76287 Rheinstetten (DE)
(74) Vertreter: Witte, Alexander, Dr.-Ing.
(86) Internationale Anmeldenummer: DE9000193
(87) Internationale Veröffentlichungsnummer: WO9010880

(56) Entgegenhaltungen:
- FR-A- 2 621 702
- GB-A- 2 198 540
- US-A- 3 526 002
- US-A- 4 766 385
- IEEE Transactions on Geoscience Electronics, Band GE-8, Nr. 4, Oktober 1970, (New York, US), C.L. Buchanan; "Optical and magnetic instruments for mapping the ocean floor", Seiten 320-325
- Elektrotechnische Zeitschrift/Ausgabe B, Band 17B, Nr. 7, 1965, (Berlin, DE), G.K.M. Pfestorf et al.: "Ein Verfahren zum Orten von Eisenkörpern in grosser Tiefe", Seiten 149-152
- Applied Optics, Band 24, Nr. 23, 1. Dezember 1985, Optical Society of America, (New York, US), W.P. Rothwell et al.: "Petrophysical applications of NMR imaging", Seiten 3969-3972

## Beschreibung

Die Erfindung betrifft ein Verfahren zum Lokalisieren von in wasserhaltiger Umgebung befindlichen protonenarmen Gegenständen, insbesondere zum Orten von Unterseebooten oder Seeminen in einem Meer oder einem Binnengewässer, bei dem eine von dem Gegenstand im Verhältnis zu dessen Umgebung verursachte magnetische Störung unter Ausnutzung von kernmagnetischer Protonenresonanz detektiert wird.

Die Erfindung betrifft ferner eine Vorrichtung zum Lokalisieren von in Wasser getauchten protonenarmen Gegenständen, insbesondere zum Orten von Unterseebooten oder Seeminen, mit mindestens einer Sendespule zum Anregen einer kernmagnetischen Protonenresonanz mittels eines elektromagnetischen Wechselfeldes und mit Empfangsmitteln zum Detektieren eines Resonanzsignals.

Die Erfindung betrifft ferner eine Verwendung des Verfahrens der kernmagnetischen Resonanz von Protonen.

Im Rahmen der Bekämpfung von Unterseebooten verwendet man zum Orten der Unterseeboote sowohl aktive wie auch passive Systeme.

Bei den aktiven Systemen (z.B. SONAR) wird von Bord eines suchenden Fahrzeugs, beispielsweise einer Fregatte, ein Suchsignal abgestrahlt, im allgemeinen ein Schallsignal im Schall- oder Infraschallbereich. Diese Schallsignale werden an der Oberfläche des Unterseeboots reflektiert und gelangen auf Empfänger an Bord des suchenden Fahrzeugs, so daß mittels geeigneter Auswerteverfahren aus diesen empfangenen Signalen die Position des Unterseeboots bestimmt werden kann.

Um Unterseeboote gegen solche aktive Ortungsverfahren zu schützen, ist es bekannt, das Unterseeboot an seiner Außenhülle mit einer Beschichtung zu versehen, die auftreffende Schallsignale bestmöglich absorbiert.

Auch ist bereits vorgeschlagen worden, Turbulenzen an umströmten Unterwasserteilen von Unterseebooten durch Einbringen chemischer Additive herabzusetzen (DE-OS 23 18 304).

Bei den passiven Ortungsverfahren werden hingegen physikalische Erscheinungen ausgenutzt, die vom Unterseeboot selbst verursacht werden. So ist es beispielsweise bekannt, zum Orten von Unterseebooten die Tatsache auszunutzen, daß die metallischen Teile des Unterseeboots das Erdmagnetfeld stören. Es sind daher Ortungssonden bekannt, die auf dem Prinzip der kernmagnetischen Resonanz beruhen und von Schiffen oder Flugzeugen an einer langen Leine über den abzusuchenden Bereichen des Meers geschleppt werden, um Verwerfungen des Erdmagnetfelds zu detektieren.

Ein weiteres passives Ortungsverfahren, wie es beispielsweise in der EP-PS 63 517, der EP-OS 120 520 sowie der EP-PS 213 418 beschrieben ist, beruht auf der Messung von Schallsignalen, die vom Unterseeboot abgestrahlt werden. Ein Unterseeboot strahlt nämlich in dem Umfange Schall an das umgebende Meerwasser ab, wie bewegte Teile im Unterseeboot Schwingungen an die Außenhaut übertragen. In erster Linie werden meßbare Schallsignale von bewegten Antriebselementen des Unterseeboots, also von den rotierenden Teilen des Antriebsmotors und von der Welle erzeugt, aber auch die rotierende Schraube und die von der Schraube verursachte Kavitation sind als Schallquellen zu berücksichtigen. Schließlich werden auch bei der Betätigung der Höhen- und Tiefenruder, beim Ablassen von Luft und beim Verschieben von Trimmassen Schallsignale erzeugt, die mit entsprechend empfindlichen passiven Ortungssystemen an Bord moderner Fregatten erfaßt werden können.

Bei Unterseebooten mit kerntechnischem Antrieb kommt in diesem Zusammenhang noch die Besonderheit hinzu, daß Kernreaktoren, wie sie an Bord von Unterseebooten eingesetzt werden, üblicherweise mit periodisch betätigten Regelstäben ausgerüstet sind. Die Regelstäbe werden mit einer vorgegebenen Frequenz im Reaktorgefäß bewegt, wobei die Eintauchtiefe der Regelstäbe einstellbar ist, so daß auf diese Weise die vom Kernreaktor abgegebene Leistung eingestellt werden kann. Infolge der periodischen Bewegung relativ großer Massen entsteht jedoch auch ein verhältnismäßig intensives Schallsignal, das zur Ortung von derartigen kerntechnisch angetriebenen Unterseebooten herangezogen werden kann.

Es ist andererseits bekannt, daß bei modernen, immer empfindlicher werdenden passiven Schallortungssystemen in immer größerem Maße auch der Schall berücksichtigt werden muß, der in der Umgebung des Unterseeboots vorhanden ist. Dieser natürliche Schall wird im wesentlichen durch Meeresströmungen, Wellengang, Fischschwärme und dgl. erzeugt.

Beim Betrieb von passiven Schallortungssystemen macht sich dieser Umgebungsschall als Rauschen bemerkbar, das je nach Umgebungsbedingungen eine gleichmäßige oder eine ungleichmäßige Frequenzverteilung annehmen kann.

Aus der DE-OS 34 06 343 ist ein Verfahren bekannt, mit dem Schallsignale von Unterseebooten, deren Intensität nur geringfügig über dem des Umgebungsrauschens liegt, aus dem Umgebungsrauschen heraus erkannt werden können.

Aus der US-PS 4 766 385 ist ein Unterwasser-Ortungsgerät zum Aufspüren von im Meeresboden vergrabenen Seeminen bekannt. Das Ortungsgerät besteht aus einem kabelgeschleppten, jedoch mit einem Eigenantrieb versehenen, unbemannten Unterwassergefährt, das mit einem Protonenmagnetometer ausgerüstet ist, um die Anwesenheit von Seeminen im erdmagnetischen Feld zu erkennen.

Aus der EP-OS 237 323 ist ein Verfahren zum Ausmessen von Bohrlöchern für die Ölindustrie bekannt. Bei diesem Verfahren wird eine Kernresonanz-Sonde in ein Bohrloch abgesenkt, um Kernresonanz-Messungen im Außenraum der Sonde, d.h. in dem das Bohrloch umgebenden Erdreich vornehmen zu können. Dabei wird mit Hilfe der magnetischen Kernresonanz eine Analyse der chemischen Zusammensetzung des umgebenen Erdreiches vorgenommen, um z.B. das Vorhandensein von Kohlenwasserstoffen zu erkennen.

Schließlich ist aus der DE-OS 36 90 746 eine Einrichtung zum Messen von Parametern der Lagerstätten unterirdischer Mineralien bekannt, bei der eine Drahtschleife auf der Erdoberfläche angeordnet und eine magnetische Kernresonanz in dem Bereich unterhalb der Drahtschleife angeregt wird, indem mittels der Drahtschleife ein magnetisches Wechselfeld erzeugt wird, das in Zusammenhang mit dem Erdmagnetfeld Kernresonanzen im Erdbereich unterhalb der Drahtschleife anregt. Auf diese Weise sollen bestimmte Mineralien in dem Meßbereich detektiert werden.

Die bekannten Verfahren und Vorrichtungen, soweit sie zum Orten von Unterseebooten, Seeminen oder dgl. vorgesehen sind, haben allerdings den Nachteil, daß entweder eine beträchtliche Annäherung an das zu ortende Objekt erforderlich ist oder aber daß eine Ortung aus größerer Entfernung nicht mit einer feststehenden Meßanordnung möglich ist, sondern vielmehr durch Verfahren der Meßanordnung mehrere Messungen unternommen werden müssen, um eine präzise dreidimensionale Ortung des gesuchten Objektes zu ermöglichen. Dies ist vor allem bei bewegten Objekten, beispielsweise Unterseebooten, von erheblichem Nachteil, weil dann, wenn nur eine Meßanordnung zur Verfügung steht und diese im Meßbereich verfahren werden muß, sich die Position des zu ortenden Objektes mittlerweile erheblich geändert haben kann.

Soweit die vorbekannten Verfahren und Einrichtungen zur Anregung kernmagnetischer Resonanzen außerhalb eines Labors geeignet sind, wird stets das Erdmagnetfeld als Konstantmagnetfeld eingesetzt und es werden auch spektroskopische, d.h. analytische Messungen durchgeführt, deren Meßort von der jeweiligen Position der Meßanordnung abhängt. Dies bedeutet, daß diese bekannten Einrichtungen und Verfahren zum dreidimensionalen Orten von bewegten Objekten wie Unterseebooten oder auch von festen Objekten wie Seeminen, gänzlich ungeeignet sind.

Der Erfindung liegt demgegenüber die Aufgabe zugrunde, ein Verfahren und eine Vorrichtung der eingangs genannten Art anzugeben, mit denen die vorstehend genannten Nachteile vermieden und insbesondere eine präzise mehrdimensionale Ortung bis hin zur identifizierenden Bilddarstellung des gesuchten Gegenstandes möglich ist. Vor allem soll erreicht werden, daß eine Ortung auch bei solchen Gegenständen möglich ist, die keinen oder nur einen praktisch unmeßbaren Ferromagnetismus aufweisen.

Diese Aufgabe wird gemäß dem eingangs genannten Verfahren dadurch gelöst, daß in einem Raumbereich des Wassers Bedingungen für das Auftreten einer kernmagnetischen Resonanz von Protonen des Wassers hergestellt werden, daß der Raumbereich hinsichtlich des Auftretens von Resonanzsignalen überwacht wird und daß Verminderungen der Resonanzsignale detektiert werden.

Gemäß der eingangs genannten Vorrichtung wird die der Erfindung zugrundeliegende Aufgabe dadurch gelöst, daß die Sendespule so ausgebildet und angeordnet ist, daß ein Raumbereich von mehr als 50 m³, vorzugsweise wesentlich mehr als 1000 m³ des Wassers mit dem elektromagnetischen Wechselfeld beaufschlagbar ist und daß die Empfangsmittel eine Einheit zum Erkennen einer vorbestimmten Abnahme des Resonanzsignals umfassen.

Schließlich wird die der Erfindung zugrundeliegende Aufgabe im Rahmen der eingangs genannten Verwendung noch dadurch gelöst, daß das Verfahren der kernmagnetischen Resonanz von Protonen zum makroskopischen Detektieren von protonenarmen Bereichen in einer protonenreichen Umgebung, insbesondere zum Orten von Unterseebooten oder Seeminen in einem Meer oder einem Binnengewässer verwendet wird.

Die der Erfindung zugrundeliegende Aufgabe wird auf diese Weise vollkommen gelöst.

Im Gegensatz zu dem eingangs erläuterten bekannten Verfahren bzw. der entsprechenden Vorrichtung wird nämlich nicht nur eine kernmagnetische Resonanz in einer kleinen Probe von beispielsweise einigen Kubikzentimetern Probensubstanz erzeugt, die an Bord der geschleppten Sonde angeordnet ist, es wird vielmehr in einem makroskopischen Bereich mit Dimensionen von mehreren 10, 100 oder 1000 m eine großräumige Kernresonanz erzeugt und das Gesamtsignal der angeregten Protonen des Wassers empfangen und ausgewertet. Gelangt nun in den überwachten und homogen mit protonenreichem Wasser gefüllten Raumbereich ein protonenarmer Gegenstand, beispielsweise ein metallisches Unterseeboot oder eine metallische Seemine, so kann dies leicht anhand der Abnahme des empfangenen Protonenresonanzsignals erkannt werden, weil dieses Signal sich in einem Ausmaß vermindert, der dem Verhältnis des Volumens des Gegenstandes an dem Volumen des Raumbereichs entspricht. Es ist dabei im Gegensatz zum Stand der Technik nicht erforderlich, daß der Gegenstand selbst mehr oder weniger stark ferromagnetisch ist, es kommt vielmehr lediglich darauf an, daß der Gegenstand im Verhältnis zum Wasser protonenarm ist, was auf die allermeisten in der Wehrtechnik verwendeten Materialien zutrifft. Unter "protonenarm" soll im folgenden die Eigenschaft von Werkstoffen verstanden werden, kein merkliches Protonensignal zu liefern. Die Relaxationszeiten des Werkstoffs sollen daher im Sekundenbereich liegen.

Infolgedessen lassen sich das erfindungsgemäße Verfahren und die erfindungsgemäße Vorrichtung zum Aufspüren beliebiger protonenarmer Gegenstände in protonenreicher Umgebung einsetzen, also auch zur Minensuche, zum Lokalisieren feindlicher Kampfschwimmer mit entsprechendem Tauchgerät, zum Orten von Torpedos und dgl. mehr.

Bei einer bevorzugten Ausgestaltung der erfindungsgemäßen Vorrichtung ist die Sendespule in einem Meer oder Binnengewässer angeordnet und steht mit einem mit Sende- und Empfangsmitteln versehenen Wasserfahrzeug in Verbindung.

Diese Maßnahme hat den Vorteil, daß durch Schleppen der Sendespule entlang eines vorgegebenen Kurses eine systematische Suche nach feindlichen Unterseebooten, Seeminen oder dgl. z.B. in vorgegebenen Planquadraten vorgenommen werden kann.

Dies gilt insbesondere dann, wenn das Wasserfahrzeug ein oberflächengebundenes Schiff, insbesondere eine Fregatte, ist, weil dann die Suche nach feindlichen Unterseebooten mit Abwehrmaßnahmen gegen diese Unterseeboote unmittelbar verbunden werden kann.

Bei einer weiteren Ausgestaltung der erfindungsgemäßen Vorrichtung ist die Sendespule hingegen in oder über einem Meer oder Binnengewässer angeordnet und steht mit einem mit Sende- und Empfangsmitteln versehenen Luftfahrzeug in Verbindung.

Diese Maßnahme hat den Vorteil, daß in schneller zeitlicher Folge geographisch beabstandete Planquadrate des Meeres oder Binnengewässers abgesucht werden können, indem das Luftfahrzeug, beispielsweise ein Hubschrauber oder ein marinetaugliches Flugzeug die Sendespule jeweils nach Absuchen eines ersten Planquadrates an Bord nimmt und dann zu einem anderen Planquadrat in geographischer Entfernung fliegt.

Bevorzugt können in den vorstehend genannten Fällen Mittel zum Schleppen der Sendespule parallel zur Oberfläche des Meeres oder-des Binnengewässers entlang eines vorbestimmten Kurses vorgesehen sein.

Diese Maßnahme hat den Vorteil, daß entweder von einer Position oberhalb oder von einer Position unterhalb des Meeresspiegels in der bereits genannten Weise vorgegebene Planquadrate abgesucht werden können.

Alternativ dazu ist aber auch möglich, Mittel zum Schleppen der Sendespule parallel zu einem Grund des Meeres oder des Binnengewässers entlang eines vorbestimmten Kurses vorzusehen.

Dieser Einsatz der erfindungsgemäßen Vorrichtung eignet sich insbesondere für die Fälle, in denen nach im oder am Meeresbodes angeordneten Gegenständen, insbesondere dort verankerten Minen gesucht werden soll.

Bei einer weiteren Gruppe von Ausführungsbeispielen der erfindungsgemäßen Vorrichtung ist die Sendespule stationär in einem Meer oder einem Binnengewässer angeordnet und steht mit stationären Sende- und Empfangsmitteln in Verbindung.

Diese Maßnahme hat den Vorteil, daß eine stationäre Bewachung von Küstenabschnitten, Häfen, Flußmündungen, Meerengen und dgl. in einfacher Weise möglich ist, weil die stationär angeordnete Sendespule alle protonenarmen Gegenstände, also alle herkömmlich gebauten Unterwasser- oder Oberwasserschiffe, Kampfschwimmer, Torpedos und dgl. zu lokalisieren und ggf. identifizieren gestattet.

Besonders bevorzugt ist dabei, wenn die Sendespule als Resonanzanordnung mit Abmessungen ausgebildet ist, die einem Vielfachen eines Viertels der Wellenlänge des elektromagnetischen Wechselfeldes entsprechen. Diese Konfiguration eignet sich besonders für die Überwachung von Meerengen.

Vorteil dieser Maßnahme ist, daß die Resonanzanordnung eine besonders empfindliche Messung gestattet, weil die Störung eines Resonanzzustandes besonders einfach detektiert werden kann.

Bei Abwandlungen der vorstehend genannten Ausführungsbeispiele mit stationärer Sendespule kann diese entweder im Meeresgrund vergraben oder schwebend im Meer angeordnet sein, je nachdem, wie dies im Einzelfall zweckmäßig ist.

Bei einer weiteren Gruppe von Ausführungsbeispielen ist die Sendespule Teil auch der Empfangsmittel.

Diese Maßnahme hat den Vorteil, daß lediglich eine einzige Spule verwendet zu werden braucht, die zugleich als Sende- und als Empfangsspule dient. Der apparative Aufwand, insbesondere bei den weiter oben gewürdigten mobilen Systemen wird daher deutlich vermindert.

Bei einer anderen Gruppe von Ausführungsbeispielen weisen die Empfangsmittel hingegen eine von der Sendespule getrennte Empfangsspule auf.

Diese Maßnahme hat den Vorteil, daß empfindlichere Meßanordnungen realisiert werden können, weil durch Trennung der Sendemittel von den Empfangsmitteln ein Übersprechen drastisch vermindert werden kann. Hierbei muß man sich vor Augen führen, daß bei den im vorliegenden Zusammenhang interessierenden sehr großen Meßanordnungen auch entsprechend große Sendeleistungen erforderlich sind, um ausgedehnte Raumbereiche zu überstreichen. Andererseits sind die empfangenen Resonanzsignale unter Umständen von sehr geringer Amplitude, so daß die Trennung der Sendemittel von den Empfangsmitteln zu einer deutlichen Steigerung der Detektionsgrenze führen kann.

Eine besonders gute Wirkung wird in diesem Fall dann erzielt, wenn die Empfangsspule in unmittelbarer Nähe der Sendespule angeordnet ist und sich mit ihrer Spulenfläche im wesentlichen senkrecht zur Spulenfläche der Sendespule erstreckt.

Diese Maßnahme hat den Vorteil, daß eine sogenannte Induktionsanordnung entsteht, bei der die Sendespule und die Empfangsspule geometrisch voneinander entkoppelt sind und in die Empfangsspule nur noch die von den Protonen herrührenden Resonanzsignale induziert werden.

Bei einem weiteren besonders bevorzugten Ausführungsbeispiel der erfindungsgemäßen Vorrichtung ist die Sendespule unter einem von 90° verschiedenen Winkel zur Richtung des erdmagnetischen Feldes angeordnet.

Diese Maßnahme macht sich mit Vorteil die Tatsache zunutze, daß bei einem Kernresonanzexperiment die Richtung des magnetischen Wechselfeldes senkrecht zur Richtung des magnetischen Gleichfeldes stehen sollte. Andererseits sind bei Spulenkonfigurationen der im vorliegenden Zusammenhang interessierenden Art mit extrem großen Abmessungen keine elektromagnetischen Wechselfelder erzielbar, deren Feldlinien im wesentlichen eine konstante Richtung im Meßbereich einnehmen. Es werden also bei allen verwendeten Sendespulen der hier interessierenden Art immer Komponenten des elektromagnetischen Wechselfeldes senkrecht zur Richtung des erdmagnetischen Feldes auftreten, wenn das erdmagnetische Feld als Gleichfeld für die Erzeugung der Kernresonanz herangezogen wird. Gleichwohl tritt eine Maximierung des Meßeffektes dann ein, wenn die Sendespule unter einem von 90° verschiedenen Winkel zur Richtung des erdmagnetischen Feldes angestellt ist, insbesondere unter einem Winkel von 0°, weil dann die Komponenten maximaler Feldstärke des elektromagnetischen Wechselfeldes senkrecht zum erdmagnetischen Feldes gerichtet sind.

Die Heranziehung des erdmagnetischen Feldes als Gleichfeld für die Erzeugung der Kernresonanz hat ferner den Vorteil, daß keine zusätzlichen felderzeugenden Mittel erforderlich sind, weil das erdmagnetische Feld an jedem Ort der Erde wirksam ist und nur die Inklination der Feldrichtung zur Erdoberfläche berücksichtigt werden muß. Auch ist das erdmagnetische Feld in der Regel so homogen, daß es in den abgesuchten Raumbereichen als konstant angenommen werden kann.

Bei einer weiteren Gruppe von Ausführungsbeispielen sind hingegen Feldmittel zum Erzeugen eines magnetischen Gleichfeldes vorgesehen und so ausgebildet und angeordnet, daß das Gleichfeld den Raumbereich beaufschlagt.

Diese Maßnahme hat den Vorteil, daß die Kernresonanz in dem abzusuchenden Raumbereich unabhängig vom jeweiligen erdmagnetischen Feld erzeugt werden kann, so daß mit entsprechend größeren Feldstärken des Gleichfeldes auch eine Erhöhung der Meßempfindlichkeit und damit eine Vergrößerung der Reichweite der erfindungsgemäßen Vorrichtung erzielt werden kann.

Es ist aber mit großem Vorteil auch möglich, die Feldmittel lediglich dazu zu verwenden, um zu dem erdmagnetischen Feld ein überlagertes Feld etwa gleicher Größenordnung zu erzeugen.

Bei einer Variante des vorstehend beschriebenen Ausführungsbeispiels sind z.B. die Feldmittel als Gradientenmittel ausgebildet und erzeugen in dem Raumbereich ein Gleichfeld mit definierter räumlicher Variation der Feldstärke.

Diese Maßnahme hat den Vorteil, daß eine mehrdimensionale Codierung des abzusuchenden Raumbereichs vorgenommen werden kann, in dem entweder im statischen Zustand oder durch Zeitvariation jedem Punkt in dem Raumbereich ein magnetisches Gleichfeld mit unterschiedlicher Feldstärke aufgeprägt wird, die dann in den jeweiligen Punkten auch bei unterschiedlichen experimentellen Bedingungen zu: Erzeugung von Kernresonanzen führt.

Besonders bevorzugt ist, wenn in diesem Falle die Feldmittel als Feldspule ausgebildet sind, weil bei einer Feldspule eine Vielzahl von Raumprofilen der magnetischen Feldstärke erzeugbar ist, indem die Erregung, Dimensionierung und Positionierung der Feldspule entsprechend variiert wird.

Bei einem Ausführungsbeispiel dieser Variante ist die Feldspule mit ihrer Spulenfläche im wesentlichen senkrecht zur Spulenfläche der Sendespule angeordnet.

Diese Maßnahme hat den Vorteil, daß die Feldspule dann, wenn sie zur Erzeugung des Gleichfeldes benutzt wird, für eine maximale Signalausbeute sorgt, weil beim klassischen Kernresonanzexperiment die Sendespule stets senkrecht zur Richtung des Gleichfeldes angeordnet sein muß.

Bei weiteren Varianten dieser Ausführungsbeispiele sind die Feldmittel als Permanentmagnet ausgebildet.

Diese Maßnahme hat den Vorteil, daß mit entsprechend dimensionierten Permanentmagneten Gleichfelder auch in großen Raumbereichen erzeugt werden können, ohne daß hierzu eine separate Energieversorgung erforderlich ist.

Bei weiteren Ausführungsbeispielen der Erfindung sind die Spulen als Ringspulen oder mit vieleckiger Spulenfläche oder als Gruppe von Einzelspulen ausgebildet.

Diese Maßnahmen haben den Vorteil, daß je nach den vorliegenden Einsatzbedingungen die gewünschten elektromagnetischen Wechselfelder oder Gleichfelder mit verschiedenen Geometrien erzeugt bzw. die Resonanzsignale mit verschiedenen Spulengeometrien erfaßt werden können. Es versteht sich jedoch, daß darüberhinaus auch noch andere Spulenformen, beispielsweise Sattelspulen oder dgl. eingesetzt werden können.

Bevorzugt ist in diesem Zusammenhang ferner, wenn die Spulen mit einem ferromagnetischen Kern versehen sind.

Diese Maßnahme hat den Vorteil, daß die Intensität eines erzeugten Wechsel- oder Gleichfeldes entsprechend gesteigert werden kann, wie auch die Empfindlichkeit von Empfangsspulen hierdurch steigerbar ist.

Weiterhin ist besonders bevorzugt, wenn die Spulen aus einem supraleitenden Draht gewickelt sind.

Diese Maßnahme hat den Vorteil, daß Magnetfelder großer Intensität bei nur geringem Aufwand an elektrischer Erregung erzeugt werden können.

Besonders bevorzugt ist bei diesem Ausführungsbeispiel, wenn der supraleitende Draht aus einem Hochtemperatur-Supraleiter besteht.

Diese Maßnahme hat den Vorteil, daß durch Einsatz von insbesondere keramischen Supraleitern die Spulen bei Temperaturen weit oberhalb der Temperatur des flüssigen Heliums betrieben werden können, so daß auch ein mobiler Einsatz derartiger Anordnungen möglich wird.

Eine gute Wirkung wird auch dadurch erzielt, daß die Spulen eine Spulenfläche von mehr als 10 m², vorzugsweise wesentlich mehr als 100 m² aufweisen.

Bei diesen Spulenabmessungen und entsprechender magnetischer Erregung (Amperewindungszahl) können Raumbereiche der weiter oben genannten Art bis hin zu mehreren 1000 m³ Wasser mit Wechsel- oder Gleichfeldern beaufschlagt werden.

Weiterhin ist hinsichtlich der Spulen bevorzugt, wenn diese unterschiedliche Spulenflächen aufweisen.

Dies hat den Vorteil, daß für die unterschiedlichen Spulen (Sende-, Empfangs- und Feldspulen) je nach den physikalischen Erfordernissen unterschiedliche Spulenflächen eingesetzt werden können. Bei auf einer Meeresoberfläche geschleppten Spulensystemen hat dies ferner den Vorteil, daß z.B. eine Oberflächenspule mit sehr großen Abmessungen eingesetzt werden kann, während die dazu senkrecht im Wasser stehenden weiteren Spulen mit kleineren Spulenflächen versehen sein können, um den hydrodynamischen Widerstand der Spulenanordnung und die Empfindlichkeit gegenüber Lageveränderungen der Spulen bei Schleppfahrt herabzusetzen.

Bei einer weiteren Gruppe von Ausführungsbeispielen umfassen die Empfangsmittel Abtastmittel zum lokalisierten Detektieren des Resonanzsignals.

Diese Maßnahme hat den Vorteil, daß durch Abtasten einer Mehrzahl von Messungen eine Positionsbestimmung des gesuchten Gegenstandes möglich wird.

Bei einer konkreten Variante dieses Ausführungsbeispiels wirken die Abtastmittel mit Schleppmitteln für die Sendespule zusammen und registrieren die Erkennung der vorbestimmten Abnahme des Resonanzsignals in Abhängigkeit von der Position der Sendespule.

Diese Maßnahme hat den Vorteil, daß z.B. bei einer Schleppfahrt eines Spulensystems das Resonanzsignal in Abhängigkeit von der jeweiligen Position des Suchfahrzeugs auf dem Kurs registriert wird, so daß bei der Erkennung einer vorbestimmten Abnahme des Resonanzsignals eine örtliche Zuordnung zu einer Position auf dem Kurs möglich wird. Dies führt zu einer eindimensionalen Ortungsmöglichkeit der Gegenstände.

Bei anderen Varianten des Ausführungsbeispiels umfassen die Abtastmittel hingegen kernspintomographische Bildgebungsmittel, die die Erkennung der vorbestimmten Abnahme des Resonanzsignals separat für näherungsweise punktförmige Segmente eines mehrdimensionalen Koordinatenrasters registrieren.

Diese Maßnahmen haben den wesentlichen Vorteil, daß z.B. auch bei einer stillstehenden Spulenanordnung durch Variation elektrischer Parameter eine punktweise befrage des Raumbereichs möglich ist und nacheinander ausgemessen werden kann, ob sämtliche Segmente des Raumbereichs ein Resonanzsignal liefern, das einer vollständigen Füllung des Raumbereichs mit signalgebenden Protonen entspricht. Auf diese Weise kann in einem mehrdimensionalen Koordinatenraster ein Bild eines protonenarmen Gegenstandes erzeugt werden, in dem die Raumsegmente markiert werden, in denen das Resonanzsignal vom Resonanzsignal der protonenreichen Wasserumgebung nach unten abweicht. Huf diese Weise läßt sich also eine Ortung der Gegenstände in drei Raumkoordinaten vornehmen, also auch hinsichtlich der Tauchtiefe, und bei entsprechend hochwertiger Bilderzeugung ist sogar eine Identifizierung der Gegenstände möglich. Bei der Ortung von Unterseebooten kann auf diese Weise also die exakte Position des Unterseeboots in Oberflächenkoordinaten und Tauchtiefe ermittelt werden sowie ggf. auch durch entsprechend feine Bildgebung eine Identifizierung der Bauart des Unterseeboots vorgenommen werden, damit dann entsprechende Abwehrmaßnahmen ergriffen werden können.

Bei einer ersten praktischen Variante dieses Ausführungsbeispiels weisen die Bildgebungsmittel einen Impulsgenerator auf, mit dem ein Sender für die Sendespule steuerbar ist, derart, daß der Sender ein getastetes Dauerstrichsignal einstellbarer Amplitude und einstellbaren Tastverhältnisses abgibt.

Diese Merkmale machen sich die Tatsache zunutze, daß bei der gepulsten Kernresonanz sogenannte 90°- oder 180°-Impulse durch geeignetes Einstellen der Amplitude und der Impulsdauer des nach einer Rechteckfunktion oder einer geeigneten Hüllkurve getasteten Dauerstrichsignals erzeugt werden können. Variiert man also z.B. die Amplitude des getasteten Dauerstrichsignals, so können 90°- bzw. 180°-Impulse in definierten Tiefen des Meeres erzeugt werden. Benutzt man diese Impulse, um Spin-Echo-Impulsfolgen zusammenzustellen, kann in einfacher Weise ermittelt werden, ob in einer bestimmten Tiefe des Meeres ein protonenarmer Gegenstand vorhanden ist.

Bei einer weiteren Variante umfassen die Bildgebungsmittel ein Netzgerät zum Einstellen definierter Gradienten in einem in dem Raumbereich erzeugten Gleichfeld.

Diese Maßnahme hat den Vorteil, daß in der bereits weiter oben angedeuteten Weise eine magnetische Codierung des Raumbereichs vorgenommen wird, indem jedem Raumpunkt des Bereichs ein magnetisches Gleichfeld unterschiedlicher Intensität aufgeprägt wird, so daß kernmagnetische Resonanzen isoliert an jedem dieser Punkte im Raum erzeugt werden kann, indem die übrigen Parameter des elektromagnetischen Wechselfeldes entsprechend variiert werden kann.

Bei einer weiteren Variante umfassen die Bildgebungsmittel eine Durchstimmeinheit für einen die Sendespule speisenden Sender.

Diese Maßnahme hat den Vorteil, daß entweder durch gleichmäßige Variation der Frequenz des elektromagnetischen Wechselfeldes ebenfalls Kernresonanzen an definierten Einzelpunkten oder entlang von Einzelflächen des Raumbereichs angeregt werden können, weil nur in diesen Punkten bzw. Flächen bei einer bestimmten Frequenz der Quotient von magnetischer Feldstärke und Frequenz dem gyromagnetischen Verhältnis von Protonen entspricht, oder daß andererseits durch breitbandige Einstrahlung das Gesamt-Protonensystem angeregt und die Resonanzsignale auf der Empfängerseite mittels Fourier-Transformation hoch-empfindlich verarbeitet werden können.

Bei einer weiteren Variante dieses Ausführungsbeispiels variiert die Durchstimmeinheit die Frequenz des Senders stufenweise, derart, daß in einem Resonanzsystem unterschiedliche Resonanzmoden erzeugt werden.

Diese Maßnahme eignet sich insbesondere für solche Konfigurationen, bei denen die Elemente des Resonanzsystems, beispielsweise beidseits einer Meerenge angeordnet sind und im Abstande eines Vielfachen eines Viertels der Wellenlänge des elektromagnetischen Wechselfeldes angeordnet bzw. entsprechend lang sind. Es können dann in dem so gebildeten resonanzfähigen System Resonanzen in unterschiedlichen Resonanzmoden erzeugt werden, bei denen die Verteilung der Feldlinien des elektromagnetischen Wechselfeldes in Abhängigkeit vom jeweiligen Schwingungsmodus variiert. Auch hierdurch kann eine räumliche Auflösung des Raumbereichs erreicht werden, die wiederum zu einer Bildgebung verarbeitet werden kann.

Bei einer weiteren Variante des Ausführungsbeispiels umfassen die Bildgebungsmittel Einrichtungen zum Verändern der Lage der Sendespule, wobei die Sendespule ein elektromagnetisches Wechselfeld mit definierter räumlicher Variation der Feldstärke erzeugt.

Diese Maßnahme hat den Vorteil, daß die in der Praxis unvermeidbare Inhomogenität der Sendespule dazu ausgenutzt wird, um durch gezielte Lageberänderung, beispielsweise durch Kippen der Sendespule nacheinander verschiedene Punkte des Raumbereichs mit Feldlinien unterschiedlicher Ausrichtung und Intensität des Magnetfeldes zu beaufschlagen.

Entsprechendes gilt bei einer anderen Variante, bei der die Bildgebungsmittel Einrichtungen zum Verändern der Lage von Feldmitteln umfassen, wobei die Feldmittel ein Gleichfeld mit definierter räumlicher Variation der Feldstärke erzeugen.

Schließlich können auch die Bildgebungsmittel bei einer noch anderen Variante eine Vielzahl von Sende- oder Empfangsspulen umfassen, die selektiv ansteuerbar sind.

Auch diese Maßnahme hat den Vorteil, daß durch zeitlich aufeinanderfolgende Ansteuerung jeweils einer oder unterschiedlicher Kombinationen mehrerer Spulen die Punkte im Raumbereich mit unterschiedlichen Feldstärken des elektromagnetischen Wechselfeldes oder des Gleichfeldes beaufschlagt werden können.

Bei weiteren Ausführungsbeispielen der Erfindung ist die Einheit zum Erkennen der vorbestimmten Abnahme des Resonanzsignals so abgestimmt, daß eine Alarmanzeige betätigt wird, wenn die Abnahme einem protonenarmen Volumen in dem Raumbereich entspricht, das näherungsweise gleich dem Volumen eines Unterseebootes oder, bei einer anderen Variante, einer Seemine ist.

Diese Maßnahme hat den Vorteil, daß durch Vorgabe unterschiedlicher Schwellwerte bereits eine Grobrasterung der Art der erkannten Objekte vorgenommen werden kann.

Bei den vorstehend gewürdigten Ausführungsbeispielen wurde davon ausgegangen, daß in dem Wasser des Raumbereichs Protonen-Kernresonanzen angeregt werden, so daß bei einer Ausnutzung des erdmagnetischen Feldes als Gleichfeld dem elektromagnetischen Wechselfeld eine Frequenz von etwa 2 kHz gegeben werden müßte, damit dies dem gyromagnetischen Verhältnis von Protonen entspricht.

Weitere Vorteile ergeben sich aus der Beschreibung und der beigefügten Zeichnung.

Auführungsbeispiele der Erfindung sind in der Zeichnung dargestellt und werden in der nachfolgenden Beschreibung näher erläutert. Es zeigen:
- Fig. 1: eine schematisierte perspektivische Darstellung einer Gefechtslage, in der eine Fregatte ein in einem Meer getauchtes Unterseeboot nach Oberflächenkoordinaten und Tauchtiefe ortet;
- Fig. 2: eine schematisierte Seitenansicht der Situation von Fig. 1 zur Erläuterung der wirksamen Magnetfelder;
- Fig. 3: eine Darstellung zur Erläuterung der kernmagnetischen Resonanz;
- Fig. 4: ein erstes Blockschaltbild einer erfindungsgemäß verwendeten Kernresonanz-Apparatur in Brückenschaltung;
- Fig. 5: ein zweites Blockschaltbild einer erfindungsgemäß verwendeten Kernresonanz-Apparatur in Induktionsanordnung;
- Fig. 6: eine graphische Darstellung eines mit der Anordnung gemäß Fig. 4 gemessenen Kernresonanzsignals;
- Fig. 7: eine graphische Darstellung eines mit der Anordnung gemäß Fig. 5 gemessenen Kernresonanzsignals;
- Fig. 8: eine Darstellung ähnlich Fig. 2 zur Erläuterung der Reichweite einer erfindungsgemäßen Vorrichtung;
- Fig. 9: eine weitere Darstellung ähnlich Fig. 2 zur Erläuterung einer erfindungsgemäßen Ortung einer vergrabenen Seemine;
- Fig. 10: eine weitere Darstellung ähnlich Fig. 2 zur Erläuterung unterschiedlicher Anordnungen erfindungsgemäßer Vorrichtungen in einem Meer;
- Fig. 11: eine Darstellung zur Erläuterung einer gepulsten Kernresonanz;
- Fig. 12 bis 14: Zeigerdarstellungen zur Erläuterung eines Kernresonanz-Spin-Echo-Experimentes;
- Fig. 15: eine zeitliche Darstellung eines Impulsprogrammes zur Erzeugung des anhand der Fig. 12 bis 14 veranschaulichten Experimentes;
- Fig. 16: eine weitere Darstellung ähnlich Fig. 2 zur Erläuterung einer Tiefencodierung mit Hilfe einer Variation der Feldstärke eines elektromagnetischen Wechselfeldes;
- Fig. 17: eine Darstellung zur Erläuterung einer zweidimensionalen Bildgebung gemäß einem erfindungsgemäßen Verfahren;
- Fig. 18: eine Darstellung ähnlich Fig. 17, jedoch für eine dreidimensionale Bilddarstellung;
- Fig. 19: eine weitere Darstellung ähnlich Fig. 2, jedoch für den Fall des Aufbringens eines zusätzlichen statischen Magnetfeldes;
- Fig. 20: eine Darstellung zur Erläuterung einer erfindungsgemäß verwendeten Drei-Spulen-Anordnung;
- Fig. 21: eine Darstellung zur Erläuterung eines erfindungsgemäß verwendeten Spulen-Arrays.

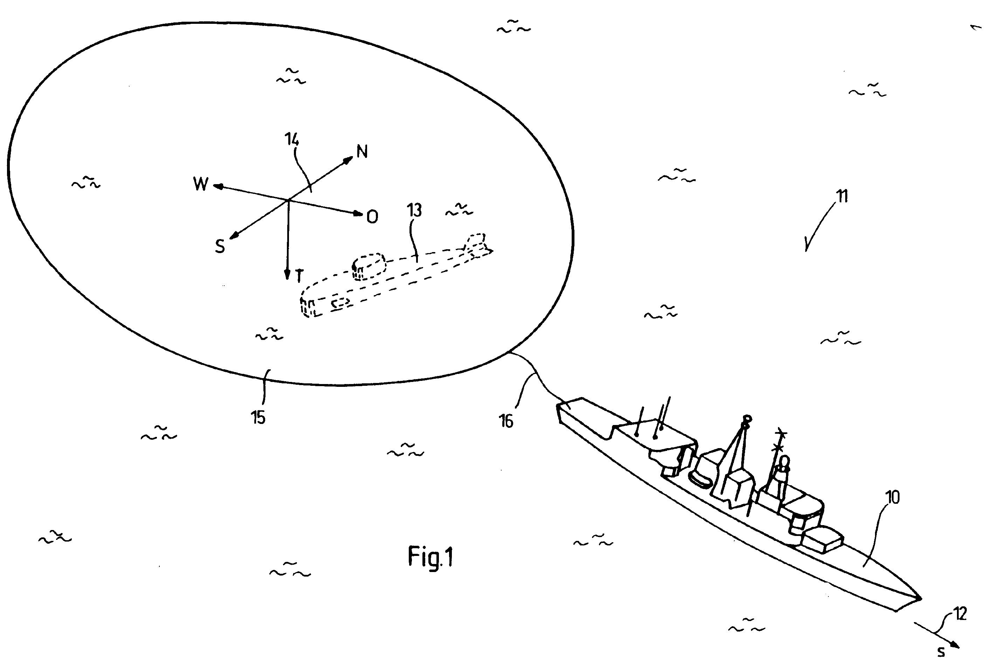

In Fig. 1 bezeichnet 10 eine Fregatte, wie sie zum Orten und Bekämpfen von Unterseebooten oder zum Orten und Bergen von Seeminen oder dgl. eingesetzt werden kann. Die Fregatte 10 befindet sich auf ihrer Fahrt in einem Meer 11 entlang eines mit einem Pfeil 12 symbolisierten Kurses s. In räumlicher Nähe der Fregatte 10 ist ein Unterseeboot 13 getaucht, dessen Position in einem mit 14 symbolisierten Koordinatensystem nach Oberflächenkoordinaten N, S, W und O sowie nach Tauchtiefe T bestimmt werden soll. Hierzu hat die Fregatte 10 eine Sendespule 15 ausgelegt, die über ein geeignetes Kabel 16 mit der Fregatte 10 verbunden ist und von dieser über ein vorgegebenes Suchgebiet entlang des Kurses s geschleppt wird.

Die Sendespule 15 schwimmt vorzugsweise auf oder kurz unterhalb der Oberfläche des Meeres 11 und ist hierzu mit geeigneten Schwimmkörpern und Mitteln zum Beibehalten einer großen Aufspannfläche versehen, wie sie in Fig. 1 der Übersichtlichkeit halber nicht näher dargestellt sind. Es versteht sich dabei, daß die Sendespule 15 auch von einem oder mehreren Hubschraubern gehalten bzw. geschleppt werden kann.

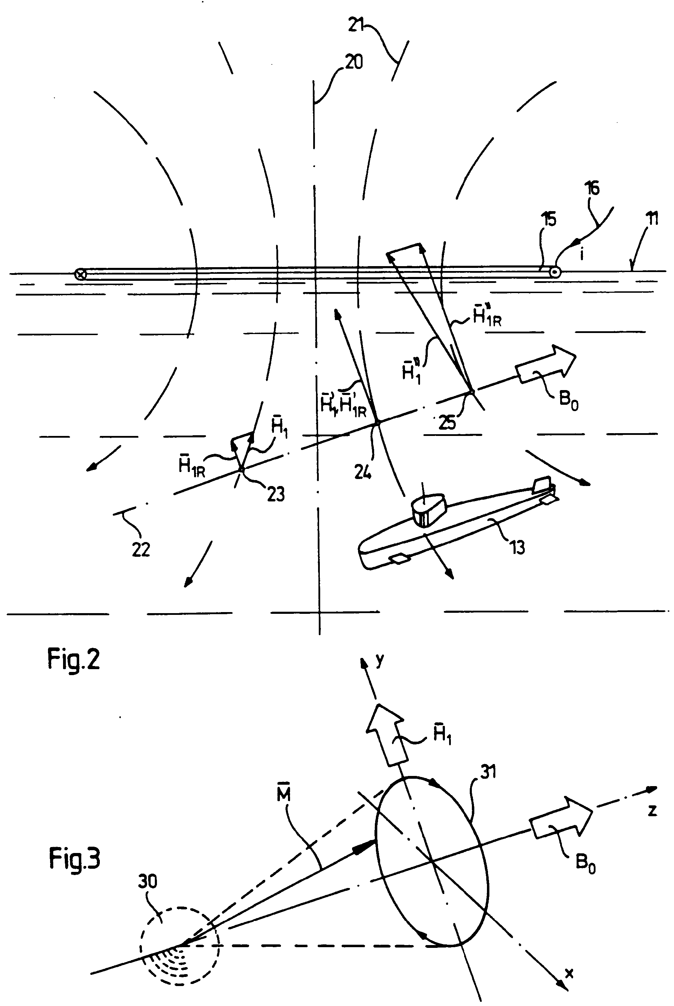

Fig. 2 zeigt nochmals die Verhältnisse der Fig. 1, jedoch in Seitenansicht und man erkennt die Sendespule 15 mit einer vertikal gerichteten Spulenachse 20. Die Sendespule 15 wird über das Kabel 16 mit einem Hochfrequenzstrom i gespeist, so daß die Sendespule 15 ein elektromagnetisches Wechselfeld mit Feldlinien 21 erzeugt, deren zugehörige komplexe Feldstärke in Fig. 2 mit H₁ an den entsprechenden Vektoren angegeben ist.

In dem in Fig. 2 dargestellten Raumbereich ist ferner das erdmagnetische Feld wirksam, das in Fig. 2 mit einem Pfeil B₀ symbolisiert dargestellt ist. Das erdmagnetische Feld B₀ verläuft in dem in Fig. 2 dargestellten Raumbereich in einer Richtung 22, deren Inklination zur Erdoberfläche von der geographischen Lage des jeweiligen Raumbereichs abhängt.

Es ist bekannt, daß das lokal im wesentlichen homogene Erdmagnetfeld einen Betrag von etwa 0,5 Gauß (50 µT) hat. Die Inklination gegen die Erdoberfläche hängt von der geographischen Breite ab und variiert zwischen 0° am Äquator und 90° an den magnetischen Polen der Erdkugel.

Das erdmagnetische Feld B₀ kann damit zur Erzeugung einer kernmagnetischen Resonanz der Protonen, d.h. der Wasserstoffatome des Wassers des Meeres 11 verwendet werden.

Fig. 3 zeigt in äußerst schematisierter Darstellung ein solches Proton 30, dessen Magnetisierungsvektor M in Richtung des erdmagnetischen Feldes B₀ ausgerichtet ist und entlang einer Bahn 31 um diese Richtung, die in Fig. 3 mit einer z-Achse eines gedachten Koordinatensystems zusammenfällt, präzediert. Legt man nun in einer zur z-Richtung orthogonalen Ebene x/y ein elektromagnetisches Wechselfeld H₁ an, wie mit einem weiteren Pfeil in Fig. 3 symbolisiert, so kann die Präzessionsbewegung sämtlicher Magnetisierungsvektoren M aller Protonen 30 eines bestimmten Raumbereichs synchronisiert werden. Die Frequenz des elektromagnetischen Wechselfeldes H₁ ergibt sich dabei aus der Stärke des wirkenden Gleichfeldes, hier also des erdmagnetischen Erdfeldes B₀ und zwar über das sogennante gyromagnetische Verhältnis, das den Quotienten von Frequenz und Feldstärke für jede kernresonanzaktive Kernart charakterisiert. Bei Protonen beträgt das gyromagnetische Verhältnis etwa 4 kHz/G, so daß im Erdmagnetfeld von 0,5 G eine Kernresonanzfrequenz von etwa 2 kHz vorliegt. Dies entspricht einer Vakuum-wellenlänge von etwa 150 km bzw. einer Wellenlänge im Wasser, dessen Dielektrizitätskonstante mit etwa 9 angenommen werden kann, von etwa 17 km.

Wie bereits erwähnt, muß das zum Anregen der Kernresonanz eingestrahlte elektromagnetische Wechselfeld H₁ senkrecht zur Richtung des vorhandenen Gleichfeldes stehen. Da die Feldlinien 21 des von der Spule 15 in Fig. 2 erzeugten elektromagnetischen Wechselfeldes gekrümmt verlaufen, ist jeweils die Projektion des Feldstärkevektors H₁ an jedem Punkte des Raumbereichs zu berücksichtigen.

In Fig. 2 ist in einem ersten Punkt 23 zu erkennen, daß die Projektion des Feldstärkevektors H₁ nur H_{1R} beträgt, weil im ersten Punkte 23 die Feldlinie unter einem relativ spitzen Winkel die Richtung 22 des erdmagnetischen Feldes B₀ schneidet. In einem zweiten Punkt 24 stimmt die Projektion H_{1R}' des Feldstärkevektors H₁ hingegen in etwa mit diesem überein, weil im zweiten Punkte 24 die Feldlinie 21 die Richtung 22 etwa unter 90° schneidet. In einem dritten Punkt 25 ist hingegen die Projektion H_{1R}'' wieder kleiner als der Vektor H_{1R}''. Allerdings nimmt die Intensität der Projektionen H_{1R}, H_{1R}' und H_{1R}'' vom ersten Punkte 23 zum dritten Punkt 25 hin zu, weil die Intensität der Feldstärke des elektromagnetischen Wechselfeldes H₁ in Richtung der Spulenachse 20 zur Spule hin zunimmt.

Insgesamt bedeutet dies, daß bei einer praktisch realisierbaren Einstrahlung eines elektromagnetischen Wechselfeldes H₁ mit einer definierten räumlichen Verteilung der Feldstärkevektoren H₁ nach Betrag, Richtung und Phase gerechnet werden muß.

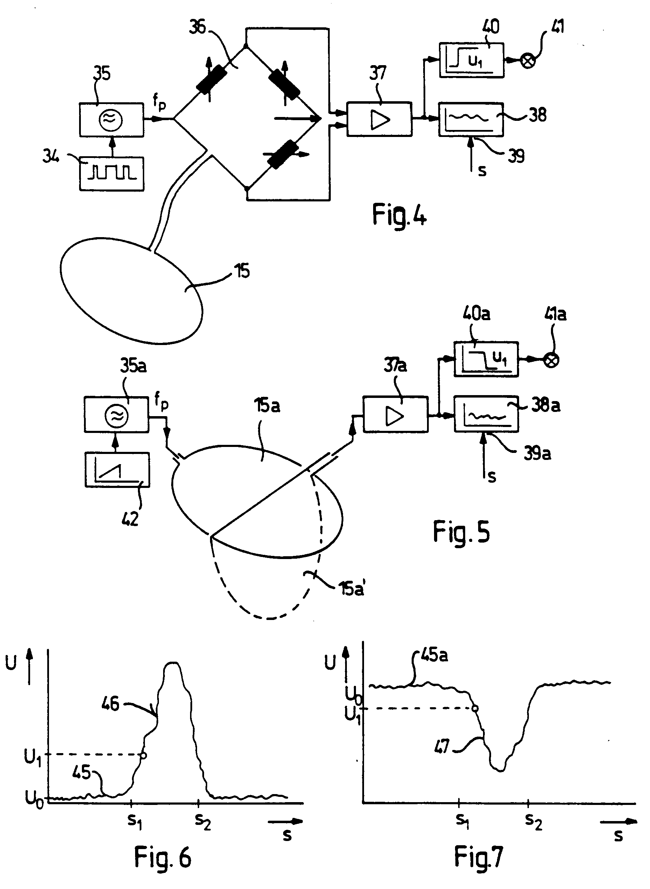

Fig. 4 zeigt ein Blockschaltbild, bei dem ein z.B. von einem Impulsgenerator 34 steuerbarer Sender 35 eine Brückenschaltung 36 speist, die in drei Brückenzweigen einstellbare normierte komplexe Widerstände und im vierten Brückenzweig die Sendespule 15 aufweist. Im Querzweig der Brückenschaltung 36 ist ein Verstärker 37 angeordnet, der ausgangsseitig mit einem Schreiber 38 oder einem sonstigen Speicher verbunden ist, dem über einen Eingang 39 ein dem Kurs s entsprechendes Signal zuführbar ist. Der Ausgangs des Verstärkers 39 ist ferner an eine Schwellwertstufe 40 angeschlossen, die ihrerseits eine Alarmanzeige 41 ansteuert.

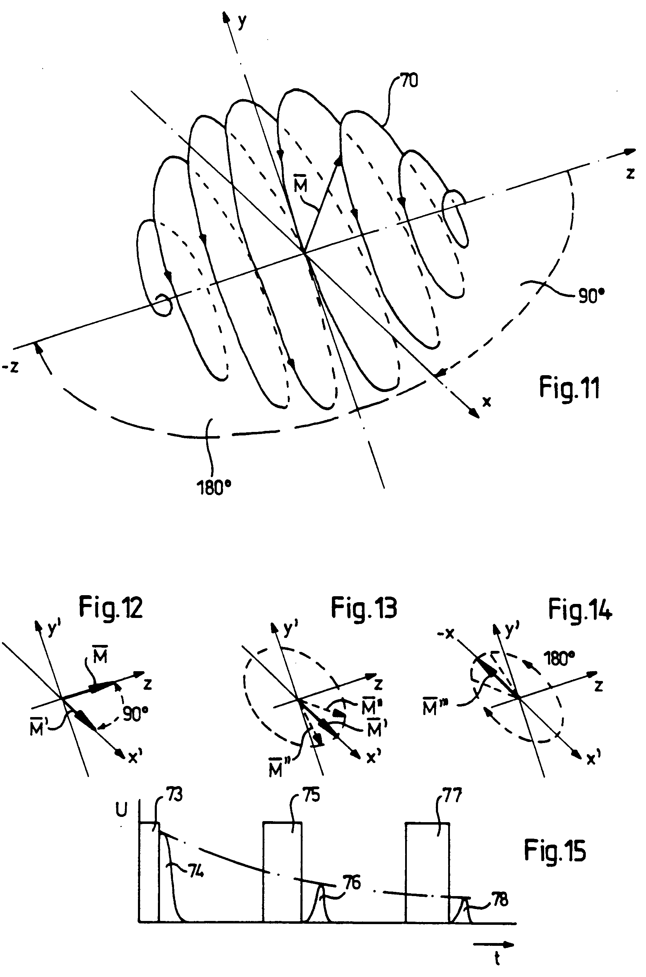

Im Falle der Verwendung eines Impulsgenerators 34 zur Anregung gepulster Kernresonanzen, wie dies weiter unten anhand der Fig. 11 bis 15 noch erläutert wird, kann zweckmäßigerweise vor dem Verstärker 37 ein Schalter vorgesehen sein, um den Eingang des Verstärkers 37 während der Impulsdauer zu sperren und in den Impulspausen zu öffnen.

Fig. 5 zeigt demgegenüber eine variierte Anordnung, bei der ein von einer Durchstimmeinheit 42 steuerbarer Sender 35a lediglich eine Sendespule 15a speist. Eine von der Sendespule 15a galvanisch getrennte Empfangsspule 15a`, deren Spulenfläche vorzugsweise senkrecht zur Spulenfläche der Sendespule 15a steht, ist ihrerseits an einen Verstärker 37a angeschlossen, dem die bereits zu Fig. 4 erläuterten Schaltelemente nachgeordnet sind.

Die Wirkungsweise der Anordnungen gemäß den Fig. 4 und 5 ist wie folgt:

Befindet sich bei der Anordnung gemäß Fig. 4 die auch als Empfangsspule wirkende Sendespule 15 im Meer 11, so wird bei der oben beschriebenen Einstellung der Frequenz des Senders 35 auf die Protonen-Resonanzfrequenz f_{P} in der Umgebung der Sendespule 15 Protonenresonanz im umgebenden Wasser des Meeres 11 angeregt. Hierdurch ändert sich der komplexe Widerstand der Sendespule 15, was zu einer entsprechenden Verstimmung der Brückenschaltung 36 führt. Durch Einstellung der komplexen Referenzwiderstände der Brückenschaltung 36 kann nun die Spannung im Querzweig während der Suchfahrt der Fregatte 10 auf Null eingestellt werden. In Fig. 6 ist dies durch ein Kernresonanzsignal 45 dargestellt, das in etwa die Amplitude 0 aufweist. Im Schreiber 38 wird das in Fig. 6 dargestellte Diagramm registriert, aus dem sich ergibt, daß bis zur Kursposition s₁ keine Veränderung im angeregten bzw. empfangenen Kernresonanzsignal eingetreten ist.

Gelangt nun jedoch das Unterseeboot 13 in den von der Sendespule 15 überstrichenen Raumbereich, so vermindert sich das empfangene Resonanzsignal entsprechend, weil jetzt nur noch ein geringeres Volumen an Wasser zu Protonenresonanzen angeregt wird. Das Unterseeboot besteht nämlich im wesentlichen aus Metall und eingeschlossener Luft, also einem protonenarmen oder sogar protonenfreien Material, so daß der vom Unterseeboot 13 eingenommene Raumbereich nicht mehr zur Aussendung eines Protonen-Resonanzsignals beiträgt. Das von der Sende/Empfangs-Spule 15 aufgenommene Resonanzsignal vermindert sich also in dem Ausmaße, wie das Volumen des von der Sendespule 15 überstrichenen Raumbereichs sich zum Volumen des Unterseebootes 13 verhält.

Die beim Eindringen des Unterseebootes 13 in den von der Sendespule 15 erfaßten Raumbereich erzeugte Verstimmung der Brückenschaltung 36 ist in Fig. 6 deutlich als ein Anstieg 46 zu erkennen. Der Anstieg 46 dauert bis zur Kursposition s₂ an, an der das Unterseeboot 13 den von der Sendespule 15 überstrichenen Raumbereich wieder verlassen hat.

In der Schwellwertstufe 40 kann nun ein Schwellwert U₁ der Spannung U im Querzweig der Brückenschaltung 36 vorgegeben werden, der zu einer Auslösung der Alarmanzeige 41 führt.

Bei der Anordnung der Fig. 5 wird hingegen stets ein maximales Kernresonanzsignal in die orthogonal zur Sendespule 15a angeordnete Empfangsspule 15a induziert, wie durch ein Kernresonanzsignal 45a in Fig. 7 angedeutet, das einer Spannung U₀ an den Klemmen der Empfangsspule 15a` entspricht.

Gelangt nun hingegen das Unterseeboot 13 in den Meßbereich der Sendespule 15a, vermindert sich in der bereits beschriebenen Weise das erzeugte Kernresonanzsignal im Verhältnis der Volumina des Raumbereiches und des Unterseebootes 13 und es wird nur noch eine geringere Spannung in die Empfangsspule 15a` induziert. Dies macht sich in Fig. 7 in einem Einbruch 47 bemerkbar, der von der Kursposition s₁ bis zur Kursposition s₂ andauert. In diesem Falle wird man die Schwellwertstufe 40a so einstellen, daß bei Unterschreiten der Spannung U₁ die Alarmanzeige 41a ausgelöst wird.

Der Impulsgenerator 34 in Fig. 4 sowie die Durchstimmeinheit 42 in Fig. 5 können dazu verwendet werden, um statt eines Dauerstrichsignales konstanter Frequenz und Amplitude ein getastetes Dauerstrichsignal oder ein frequenzvariables Signal oder ein Signal variabler Amplitude oder ein Rauschsignal oder Kombinationen dieser Signale zu erzeugen, wie dies weiter unten anhand der Fig. 11 folgende noch erläutert werden wird.

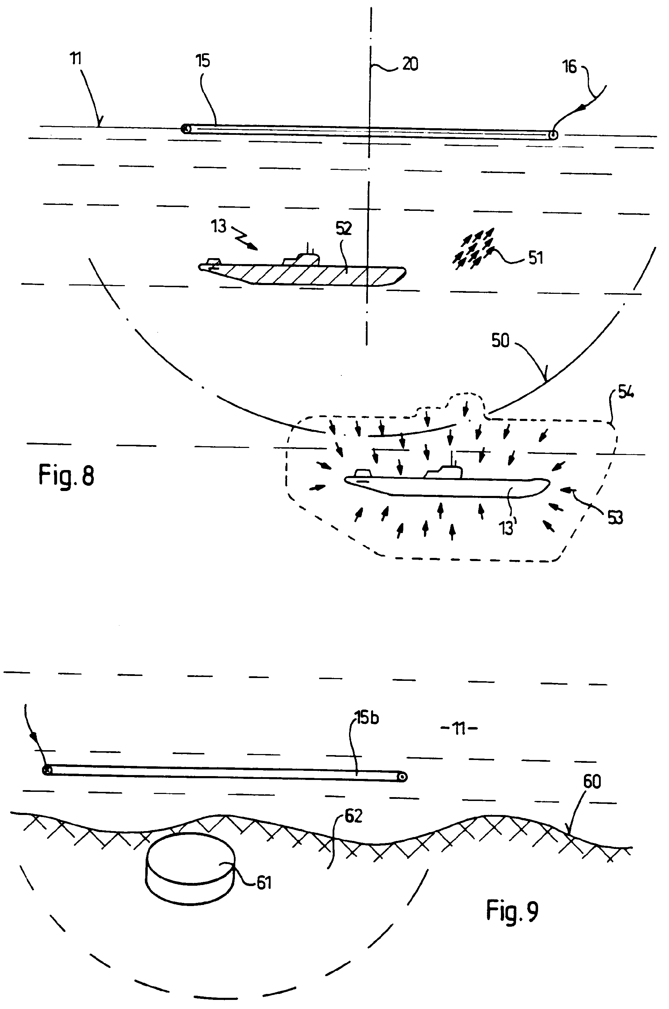

In Fig. 8 ist wiederum eine Ansicht ähnlich Fig. 2 gezeigt und mit 50 ist der Raumbereich angedeutet, der mit Hilfe der Sendespule 15 überstrichen werden kann. Unter "Raumbereich" ist dabei der räumliche Bereich in der Umgebung der Sendespule 15 zu verstehen, in dem noch ein meßbares Kernresonanzsignal bei den Protonen des Wassers des Meeres 11 erzeugt und detektiert wird. Selbstverständlich hängt die Ausdehnung des Raumbereichs 50 demzufolge von der Dimensionierung, der Formgebung und der Amperewindungszahl der Sendespule 15 ab.

In Fig. 8 sind mit 51 erste Protonen im Raumbereich 50 angedeutet, die sich sämtlich in Richtung des erdmagnetischen Feldes B₀ (vgl. Fig. 2) ausgerichtet haben. Die gleichmäßig im Raumbereich 50 verteilten ersten Protonen 51 tragen somit sämtlich zum Meßsignal bei.

Demgegenüber stellt das Unterseeboot 13 ein mit 52 symbolisiertes "Protonenloch" dar, weil sich an der Stelle des Unterseebootes 13 nur protonenarmes oder protonenfreies Material, insbesondere Metall, befindet. Wie bereits erwähnt, ergibt sich auf diese Weise bei Eindringen des Unterseebootes 13 in den Raumbereich 50 eine Abnahme des Kernresonanzsignals, das in erster Näherung dem Quotienten der Volumina des Raumbereichs 50 und des Protonenlochs 52 entspricht.

Allerdings führt auch ein Unterseeboot, das sich im geringfügigen Abstand vom Raumbereich 50 befindet und das in Fig. 8 mit 13` angedeutet ist, zu einem innerhalb des Raumbereiches 50 wirksamen Meßeffekt, sofern der Werkstoff, aus dem das Unterseeboot 13` hergestellt ist, eine Veränderung des erdmagnetischen Feldes B₀ bewirkt. In diesem Falle werden nämlich die bei 53 angedeuteten zweiten Protonen in unmittelbarer Umgebung des Unterseebootes 13` außer Resonanz geraten, insbesondere, wenn schmalbandig gemessen wird, weil die Resonanzfrequenz der Protonen über das gyromagnetische Verhältnis dem Absolutwert der Feldstärke streng proportional ist. Ferner werden die zweiten Protonen 53 sich nicht mehr so wie die ersten Protonen 51 streng parallel zur Richtung des erdmagnetischen Feldes B₀ ausrichten sondern vielmehr zum Unterseeboots 13` hin oder von diesem weg orientieren, was zu einem Bild führt, das von der Kontur des Unterseebootes 13` abhängt. Die anders gerichteten zweiten Protonen 53 führen daher zu einem anderen Kernresonanzsignal als die ersten Protonen 51, weil die zweiten Protonen 53 unterschiedlich ausgerichtet sind und sich, je nach Konfiguration des Unterseebootes 13` sogar in ihrer Gesamtwirkung gegenseitig aufheben können.

Dies führt zu einem in Fig. 8 mit 54 symbolisierten "magnetischen Loch", dessen Volumen erheblich größer als das Volumen des "Protonenlochs" sein kann.

Wenn ein Unterseeboot 13`, dessen Werkstoff ein magnetisches Loch 54 erzeugt, gesamthaft durch den Raumbereich 50 fährt, bzw. von diesem erfaßt wird, so führt dies naturgemäß zu einem wesentlich stärkeren Meßeffekt als dies weiter oben anhand des Protonenlochs 52 beschrieben wurde, weil nunmehr der Quotient der entsprechenden Volumina sich ebenfalls entsprechend ändert.

Fig. 9 illustriert einen weiteren Anwendungsbereich der Erfindung, bei dem eine Sendespule 15b nicht als Oberflächenspule an der Oberfläche des Meeres 11 angeordnet ist sondern vielmehr entweder im Abstand von einem Meeresgrund 60 schwebend aufgehängt oder im vorgegebenen Abstand über dem Meeresgrund 60 geschleppt wird.

Auf diese Weise können z.B. Seeminen 61 geortet werden, die im Schlamm 62 des Meeresgrundes 60 vergraben oder eingespült sind. Der Schlamm 62 besteht nämlich im wesentlichen auch aus Wasser, d.h. einer stark protonenhaltigen Substanz, so daß die Seemine 61 ebenfalls zu einem Protonenloch oder gar einem magnetischen Loch führt, wie dies zuvor anhand der Fig. 8 illustriert wurde.

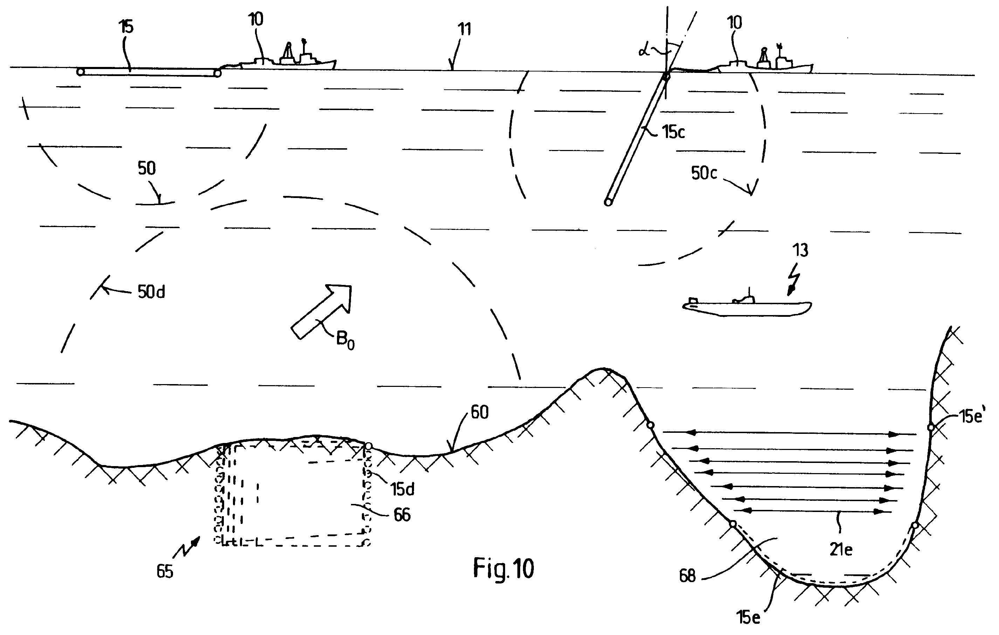

Fig. 10 zeigt einige weitere Varianten des Einsatzes der Erfindung.

Oben links in Fig. 10 ist zunächst nochmals der bereits anhand der Fig. 2 und 8 dargestellte normale Anwendungsfall dargestellt, bei dem eine Sendespule 15 von einer Fregatte 10 oder einem anderen oberflächengebundenen Schiff geschleppt wird. Es versteht sich jedoch auch hier, daß statt einer Fregatte 10 auch ein Luftfahrzeug, beispielsweise ein Hubschrauber oder ein marinetaugliches Flugzeug zum Schleppen der Sendespule 15 eingesetzt werden kann.

Oben rechts in Fig. 10 ist ein weiterer Anwendungsfall dargestellt, bei dem die Sendespule 15c unter einem Winkel zur Vertikalen geneigt geschleppt wird, wozu geeignete Treibanker und dgl. eingesetzt werden können, die in Fig. 10 der Übersichtlichkeit halber nicht dargestellt sind. Dies führt zu einer Vergrößerung des Raumbereichs 50c, wie deutlich aus Fig. 10 zu erkennen ist, weil nun zu beiden Seiten der Sendespule 15c eine Kernresonanz im Meerwasser angeregt wird. Der Neigungswinkel kann hierbei in Abhängigkeit von der Inklination des erdmagnetischen Feldes B₀ derart eingestellt werden, daß die Feldlinien des elektromagnetischen Wechselfeldes möglichst weitgehend senkrecht zur Richtung des erdmagnetischen Feldes B₀ verlaufen. Besonders zweckmäßig ist in diesem Falle, die Spulenfläche mit dem Kurs der Fregatte fluchten zu lassen, weil dann der Raumbereich beidseits des Kurses erfaßt wird.

Unten links in Fig. 10 sind zwei weitere Varianten veranschaulicht, bei denen ein Magnet 65 unter Einbeziehung ferromagnetischen Materials eingesetzt wird. In der rechten Hälfte des unten links dargestellten Ausführungsbeispiels ist hierzu ein Magnetkern 66 mit einer Sendespule 15d bewickelt und die Gesamtanordnung ist im Meeresgrund 60 eingegraben.

Schließlich zeigt Fig. 10 unten rechts noch eine weitere Variante, bei der quer zu einer Meerenge 68 oder zu beiden Seiten derselben Resonanzanordnungen 15e und 15e` angeordnet sind, deren Abmessungen ein Vielfaches eines Viertels der Wellenlänge des elektromagnetischen Wechselfeldes betragen. Wie mit Feldlinien 21e angedeutet, bildet sich auf diese Weise ein Resonanzfeld in den Resonanzanordnungen 15e und 15` aus, das in unterschiedlichen Schwingungsmoden, d.h. räumlichen Verteilungen der Feldlinien verlaufen kann. Als Resonanzanordnungen kommen dabei Hertz'sche Dipole oder parallelachsige Anordnungen von geraden Leitern infrage, die von phasenverschobenen Strömen durchflossen werden und ein Vielfaches eines Viertels der Wellenlänge lang sind.

Bei den vorstehend beschriebenen Ausführungsbeispielen wurde generell davon ausgegangen, daß die kernmagnetische Resonanz in dem als Gleichfeld verwendeten erdmagnetischen Feld B₀ angeregt wird. Es versteht sich jedoch, daß zusätzlich zu dem erdmagnetischen Feld B₀ auch extern erzeugte statische Magnetfelder herangezogen werden können und zwar mit allen Arten der Spulenkonfigurationen, wie sie für die Sendespulen 15 bis 15e in den Fig. 1 bis 10 erläutert wurden. Insbesondere eine Verstärkung eines solchen statischen Meßfeldes durch einen Magnetkern 66 oder dessen Erzeugung durch einen Permanentmagneten kommt hierfür in Frage. Mit einem solchen extern erzeugten statischen Magnetfeld kann die Meßfeldstärke von dem verhältnismäßig geringen Wert von 0,5 Gauß des erdmagnetischen Feldes B₀ um eine oder mehrere Größenordnungen gesteigert werden, so daß bei entsprechend angepaßter Meßfrequenz auch eine Erhöhung der Signalintensität eintritt, die bei Kernresonanzexperimenten näherungsweise proportional zur Meßfrequenz ist.

Da die Intensität der magnetischen Feldstärke sowohl bei einem elektromagnetischen Wechselfeld wie auch bei einem Gleichfeld bei Verwendung einer Spule von der Amperewendungszahl abhängt, wird bei einem Ausführungsbeispiel der Erfindung als Magnetspule eine Spule verwendet, die aus einem supraleitenden Draht gewickelt ist. Derartige supraleitende Spulen gestatten es bekanntlich, sehr hohe Amperewendungszahlen zu erreichen, ohne hierfür die bei normalleitenden Luftspulenanordnungen erforderliche elektrische Leistung bereitstellen zu müssen. Besonders bevorzugt ist bei Einsatzfällen der hier interessierenden Art der Einsatz moderner Hochtemperatur-Supraleiter auf keramischer Basis, wie sie heute bereits bei Temperaturen in der Größenordnung des flüssigen Stickstoffs und darüber bekannt sind.

Weiterhin wurde bei sämtlichen zuvor beschriebenen Ausführungsbeispielen lediglich eine Ortung der Gegenstände dahingehend vorgenommen, daß erkannt wurde, ob überhaupt ein solcher Gegenstand, insbesondere ein Unterseeboot 13 im Raumbereich 50 vorhanden ist oder nicht.

Um darüberhinaus auch eine exakte Position des Unterseebootes 13 nach Oberflächenkoordinaten N, S, W, O und nach der Tauchtiefe T ermitteln zu können, werden nachstehend einige weitere Ausführungsbeispiele der Erfindung beschrieben, die dies ermöglichen.

Bei einer ersten Gruppe von Ausführungsbeispielen wird hierzu das Verfahren der Impuls-Kernresonanz eingesetzt.

Fig. 11 zeigt zu dessen Veranschaulichung eine Darstellung ähnlich der Fig. 3. Während im Ruhezustand der Fig. 3 der Magnetisierungsvektor M eines Protons gleichmäßig um die Koordinatenrichtung z, d.h. die Richtung des wirksamen Gleichfeldes präzediert, wird nun das Proton durch einen Hochfrequenzimpuls, d.h. ein getastetes Dauerstrichsignal der Protonen-Resonanzfrequenz mit einstellbarer Dauer und einstellbarer Amplitude angeregt. Ein Magnetisierungsvektor M, der aus dem Ruhezustand der Fig. 3 heraus einem solchen Hochfrequenzimpuls ausgesetzt wird, durchläuft mit seiner Spitze eine im Raum geschwungene wendelförmige Bahn 70, wie dies in Fig. 11 dargestellt ist. Je nachdem, wie groß die Amplitude und die Zeitdauer des Hochfrequenzimpulses eingestellt wurde, wird der Magnetisierungsvektor M aus der Richtung z z.B. um 90° bis in die x-, y-Ebene ausgelenkt oder sogar um 180° darüber bis in die -z-Richtung. Im ersten Falle spricht man von einem sogenannten 90°-Impuls, im zweiten Falle von einem sogenannten 180°-Impuls.

Fig. 12 zeigt im sog. "rotierenden System x'/y‴ ein Experiment, bei dem zunächst einer Substanz, deren Spins durch einen gemeinsamen Magnetisierungsvektor M in z-Richtung charakterisiert sind, ein 90°-Impuls aufgeprägt wird. Der Magnetisierungsvektor M wird hierdurch aus der z-Richtung um 90° z.B. in die x'-Richtung verdreht, wie dies in Fig. 12 mit M` bezeichnet ist. Infolge von Feldinhomogenitäten fächern die Magnetisierungsvektoren aus der x'-Richtung nun beidseitig auf, wie mit M`` in Fig. 13 gekennzeichnet. Wird nun dem Spinsystem in diesem Zeitpunkt ein 180°-Impuls aufgeprägt, so laufen alle aufgefächerten Magnetisierungsvektoren M`` in der x'/y'-Ebene in die entgegengesetzte Richtung und laufen in etwa zu demselben Zeitpunkt in Richtung der -x'-Achse zusammen. Dieses sogenannte Rephasieren manifestiert sich in einem meßbaren Echoeffekt. Weitere Einzelheiten über die sog. Spin-Echo-Technik sind z.B. bei Laukien, Kernmagnetische Hochfrequenz-Spektroskopie, in: Flügge, Handbuch der Physik, Bd. XXXVIII/1, Springer 1958, S. 120-376 nachzulesen.

In Fig. 15 ist hierzu eine Impulsfolge aufgetragen, bei der 73 den 90°-Impuls der Fig. 12 bezeichnet. Durch die Umklappung der Magnetsierungsvektoren M entsteht ein Induktionssignal 74, das jedoch durch die Feldinhomogenität schnell abklingt. Mit 75 ist ein darauffolgender 180°-Impuls gemäß Fig. 13 und 14 angedeutet, der in der zuvor beschriebenen Weise zu einem Spin-Echo 76 führt. Die 180°-Impulse können bei 77 und auch noch später wiederholt werden, wodurch weitere Spin-Echos 78 usw. auftreten.

Diese Impulstechnik kann man sich im hier vorliegenden Zusammenhang zunutze machen, wenn man sich überlegt, daß die in Fig. 15 dargestellte Impulsfolge eine Rephasierung der Magnetisierungsvektoren nur dann bewirkt, wenn Amplitude und Länge der Impulse ein Umkehren der Magnetisierungsvektoren M im wesentlichen um 90° bzw. 180° bewirken.

Im Raumbereich 50 ändert sich die Länge der Impulse 73, 75 und 77 nicht. Allerdings variiert die Amplitude dieser Impulse, wie bereits oben zu Fig. 2 im Hinblick auf die im Raumbereich abnehmende Intensität von H₁ erläutert.

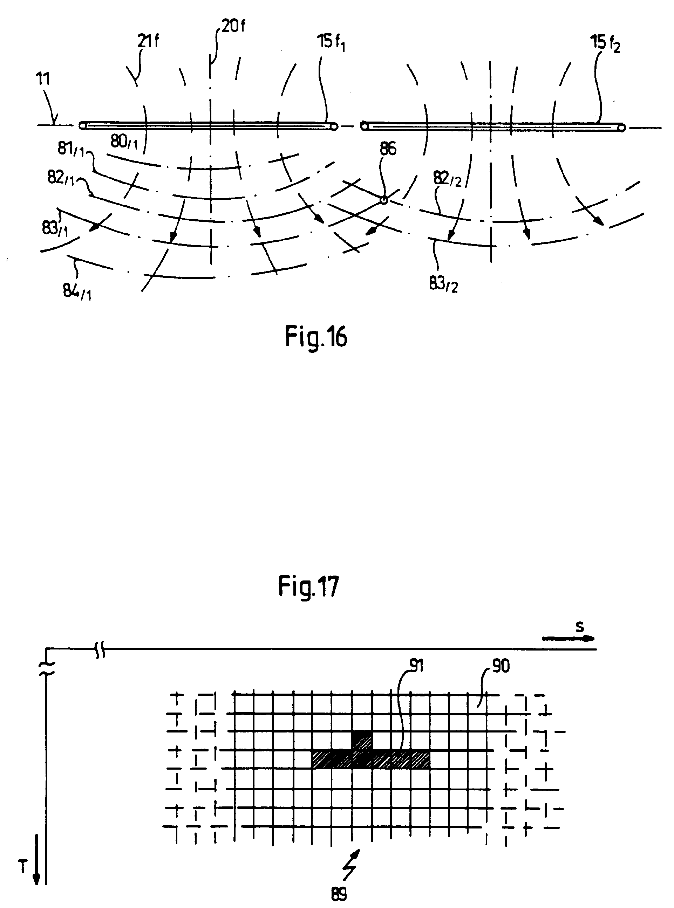

In Fig. 16 ist eine erfindungsgemäße Anordnung dargestellt, bei der zwei Sendespulen 15f₁ und 15f₂ nebeneinander auf der Oberfläche des Meeres angeordnet sind. Mit 20f ist die Spulenachse der Sendespule 15f₁ und mit 21f eine zugehörige Feldlinie bezeichnet. Mit 80/1 bis 84/1 sind in Fig. 16 nun Linien (bzw. in räumlicher Darstellung Flächen) gleicher Feldstärke des elektromagnetischen Wechselfeldes eingezeichnet, das von der Sendespule 15f₁ erzeugt wird. Es sei nun angenommen, daß auf der Linie 83/1 gerade eine Feldstärke vorliegt, bei der ein 180°-Impuls auf diejenigen Protonen ausgeübt wird, die sich auf der Linie 83/1 befinden. Liegt nun ein zu suchender protonenarmer Gegenstand in einem Punkt 86, so wird dies erkannt, weil das auf der Linie 83/1 durch 180°-Impulse selektiv erzeugte Kernresonanzsignal kleiner ist als ein auf einer anderen Linie 82/1 oder 84/1 unter Berücksichtigung der dort herrschenden Feldstärke H₁ erzeugtes Kernresonanzsignal, das nicht durch ein Protonenloch wie am Punkt 86 geschwächt ist. In der zweiten Sendespule 15f₂ wird hingegen auf der entsprechenden Linie 83/2 keine Schwächung des Kernresonanzsignales registriert, weil das Protonenloch am Punkte 86 nicht auf der Linie 83/2 liegt. Variiert man hingegen den Strom in der zweiten Spule 15f₂, so daß die 180°-Bedingung nun auf der Linie 82/2 erfüllt wird, so erscheint dort ein Signaleinbruch, weil nunmehr das Protonenloch am Punkt 86 wirksam wird.

Da die räumliche Variation der Intensität der magnetischen Feldstärke des elektromagnetischen Wechselfeldes, das von den Spulen 15f₁ und 15f₂ erzeugt wird, bekannt ist, kann durch Messungen mit variierendem Erregerstrom in den Spulen 15f₁ und 15f₂ der Punkt 86 als Schnittpunkt der Linien 83/1 und 82/2 ermittelt werden.

Auf diese Weise kann eine mindestens zweidimensionale Ortung eines protonenarmen Gegenstandes, beispielsweise eines Unterseebootes 13 vorgenommen werden.

Fig. 17 zeigt in einer beispielhaften Darstellung, daß die Variation des Erregerstromes der Spulen 15f₁ und 15f₂ gemäß Fig. 16 in ein zweidimensionales Koordinatenraster 89 umgesetzt werden kann, bei dem auf der Abszisse eine Koordinatenrichtung, die mit dem Kurs s übereinstimmt aufgetragen ist und in der Ordinate die Tiefe T. Bei während der Messung stationären Spulen 15f₁ und 15f₂ kann nun durch zyklisches Umschalten der Erregerströme des elektromagnetischen Wechselfeldes durch stufenweises Erhöhen und Vermindern der Erregerströme jedes Segment 90 des Koordinatenrasters 89 überprüft werden. Bei größeren räumlichen Gegenständen werden auf diese Weise mehrere Segmente 90 als protonenarm erkannt, so daß durch geeignete Bildgebung eine zweidimensionale Silhouette 91 des Unterseebootes 13 dargestellt werden kann. Aus der Silhouette 91 kann die Tiefe T und die Position in Richtung des Kurses s abgelesen werden.

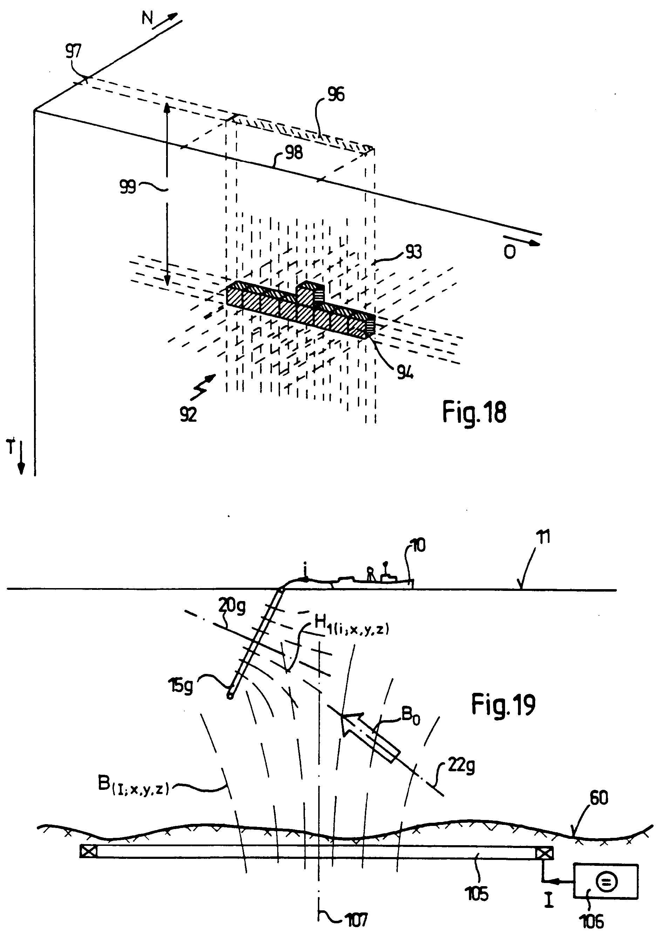

Fügt man nun zu den beiden Spulen 15f₁ und 15f₂ der Fig. 16 senkrecht zur Zeichenebene noch eine dritte Spule hinzu, so kann auch eine dreidimensionale Auflösung erreicht werden. Dies führt zu dem in Fig. 18 dargestellten dreidimensionalen Koordinatenrasters 92, dessen räumliche Segmente 93 ebenfalls durch stufenweises Verändern der Erregerströme zyklisch ab gefragt werden können, um diejenigen dreidimensionalen Segmente 93 zu ermitteln, in denen das Protonenresonanzsignal geschwächt ist oder gar verschwindet. Mittels geeigneter Bilddarstellungen kann ein dreidimensionaler Bereich 94 angezeigt werden, der der Position des Unterseebootes 13 entspricht.

Auf diese Weise kann ein Abwurfbereich 96 für Wasserbomben und dgl. bestimmt werden, der aus den Positionskoordinaten 97 und 98 des Bereichs 94 ermittelt wird. Auch die Tiefe 99 des Bereichs 94 kann in einfacher Weise gelesen werden.

Das zuvor anhand der Fig. 16 beschriebene Verfahren der selektiven Ausmessung von zweidimensionalen Segmenten 90 oder dreidimensionalen Segmenten 93 eines zwei- oder dreidimensionalen Koordinatenrasters 89 bzw. 92 ist nur ein Beispiel von mehreren.

So können darüberhinaus auch zahlreiche weitere bildgebende bzw. volumenselektive Verfahren und Vorrichtungen eingesetzt werden, wie sie aus der Kernspintomographie bekannt und z.B. bei Roth, NMR-Tomographie und Spektroskopie in der Medizin, Springer, 1984 beschrieben sind.

Bei diesen Verfahren werden einem Gleichfeld ein oder mehrere sogenannte Gradientenfelder überlagert. Hierunter versteht man statische Magnetfelder, deren Intensität in vorbestimmter Weise räumlich variiert. Superponiert man nun dem Gleichfeld nacheinander mehrere derartige Gradientenfelder, so kann eine magnetische Codierung des Raumbereichs vorgenommen werden, indem jedem Punkt im Raumbereich zu einem bestimmten Zeitpunkt ein bestimmter Intensitätswert des Gleichfeldes zugeordnet wird. Jedem dieser Punkte entspricht damit auch eine bestimmte Resonanzfrequenz, weil das gyromagnetische Verhältnis eine Konstante ist. Durch Variation der Frequenz des elektromag netischen Wechselfeldes können nun nacheinander die verschiedenen Punkte des Raumbereichs angewählt und selektiv auf das Vorhandensein von Protonen überprüft werden. Die Frequenzvariation kann dabei entweder dadurch erreicht werden, daß man die Frequenz des elektromagnetischen Wechselfeldes adiabatisch durchstimmt, d.h. einen sogenannten "Frequenzsweep" einstellt, es ist aber auch mit den bekannten Methoden der Kernspintomographie möglich, eine breitbandige Anregung des Raumbereichs mit einer Vielzahl von Frequenzen vorzunehmen und mittels Fourier-Transformation die Sprungantwort des Spinsystems im Raumbereich zu analysieren und abzubilden. Die hierzu erforderlichen Verfahren und Vorrichtungen sind an sich aus der Kernspintomographie bekannt und sollen daher der Übersichtlichkeit halber hier nicht nochmals im einzelnen erläutert werden.

Fig. 17 zeigt eine Anordnung, bei der eine Gradientenspule 105 mit zugehörigem Netzgerät 106 im Meeresgrund 60 vergraben ist. Die Gradientenspule 105 erzeugt um ihre Spulenachse 107 herum ein statisches Magnetfeld B, dessen Intensität zum einen von der Amperewindungszahl der Spule 105, zum anderen aber auch von den räumlichen Koordinaten abhängt, weil infolge der hier interessierenden Abmessungen der Gradientenspule 105 von mehreren Metern bis Kilometern und darüber an Durchmesser keine homogene Feldverteilung erzielt werden kann. Im Bereich einer Sendespule 15g, die ein elektromagnetisches Wechselfeld H₁ erzeugt, tritt somit eine Superposition des erdmagnetischen Feldes B₀, des statischen Gradientenfeldes B und des elektromagnetischen Wechselfeldes H₁ auf. Dies führt in praktisch jedem Punkt des von der Sendespule 15g überstrichenen Raumbereichs zu unterschiedlichen Meßbedingungen, so daß durch Variation der Parameter Segmente im Raumbereich nacheinander abgefragt werden können. Diese Variation kann z.B. durch Variation der Stromstärke I in der Gradientenspule 105, durch Variation der Stromstärke i in der Sendespule 15g, durch Variation der Neigung der Sendespule 15g oder durch Verfahren der Sendespule 15g mittels der Fregatte 10 erfolgen. Auch kombinierte zeitvariante Verstellungen dieser Parameter sind möglich und führen, sofern sie reproduzierbar sind, zu einer definierten Codierung aller Segmente im interessierenden Raumbereich.

Auch an dieser Stelle sei nochmals hervorgehoben, daß alle "Spulen" im Rahmen der vorliegenden Erfindung untereinander hinsichtlich Ausbildung, Dimensionierung und Lage gleichwertig zu betrachten sind, so daß die Darstellungen der anderen Abbildungen, beispielsweise der Fig. 9 und 10 gleichermaßen für Sendespulen, Empfangsspulen, Spulen zur Erzeugung eines statischen Zusatzfeldes oder Gradientenspulen gelten.

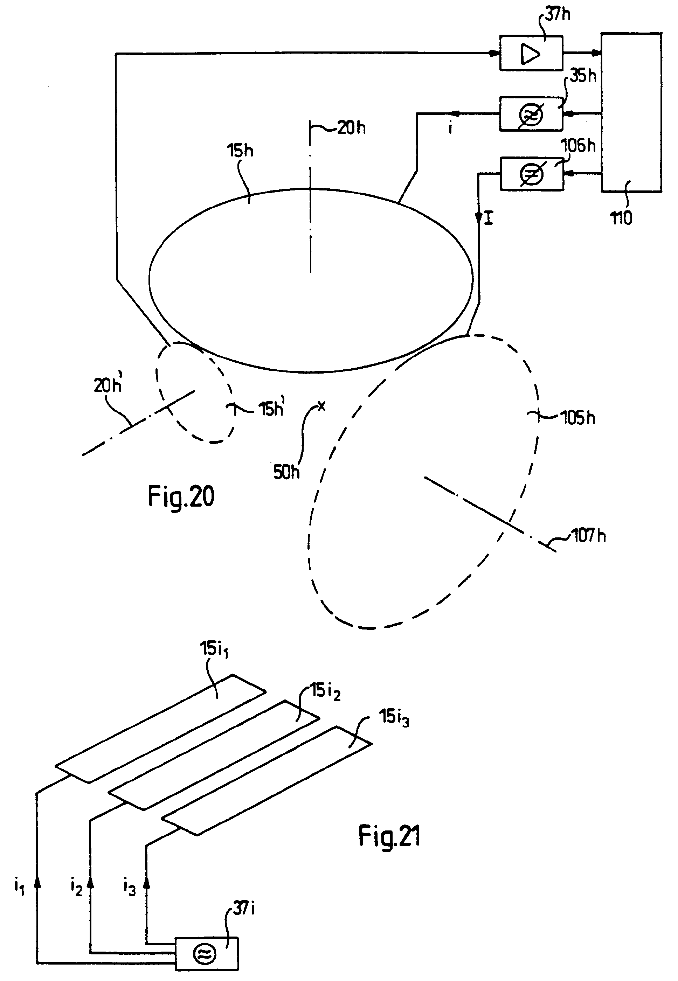

Fig. 20 zeigt eine kombinierte Anordnung, bei der eine Sendespule 15h als Oberflächenspule mit vertikaler Achse 20h vorgesehen ist. Die Sendespule 15h wird mit einem Erregerstrom i aus einem variablen Sender 35h gespeist. Eine Empfangsspule 15h` ist mit der Spulenfläche vertikal angeordnet, so daß ihre Spulenachse 20h` senkrecht zur Achse 20h der Sendespule 15h steht. Das Signal der Empfangsspule 15h` wird auf einen Verstärker 37h geleitet. Eine Spule 105h erzeugt entweder ein statisches Meßfeld oder ein Gradientenfeld, wobei die Achse 107h der Spule 105h senkrecht auf den Achsen 20h der Sendespule 15h und 20h` der Empfangsspule 15h` steht. Damit verläuft auch die Spulenfläche der Spule 105h vertikal. Die Spule 105h wird mit einem Erregerstrom I aus einem variablen Netzgerät 106h gespeist.

Ein gemeinsames Steuergerät 110 ist an den variablen Sender 35h, den Empfänger 37h sowie an das variable Netzgerät 106h angeschlossen. Das Steuergerät 110 erzeugt eines der vorstehend beschriebenen Programme zur kontinuierlichen oder getasteten Einstellung des Senders 35h sowie zur entsprechenden Einstellung des Erregerstromes I in der Spule 105h, um in dem von den Spulen 15h, 15h` und 105h überstrichenen Raumbereich 50h selektiv Segmente innerhalb eines Koordinatenrasters auf das Vorhandensein von Proionen hin zu überprüfen, wie dies weiter oben anhand der Fig. 18 veranschaulicht wurde.

Schließlich zeigt Fig. 21 noch in perspektivischer Darstellung ein sogenanntes Spulenarray 15i₁, 15i₂, 15i₃ mit rechteckförmigen Spulen, die mit separaten Erregerströmen i1, i2 und i3 gespeist werden, um im Sinne der Ausführungen zu Fig. 16 durch Variation des elektromagnetischen Wechselfeldes eine räumliche Auflösung zu erzielen. Entsprechendes gilt jedoch, wenn die Anordnung der Fig. 21 für Gradientenspulen verwendet wird, um dem Raumbereich ein entsprechendes Profil mehrerer Gradienten von statischen Magnetfeldern aufzuprägen.

Es versteht sich, daß die vorstehend beschriebenen Ausführungsbeispiele keineswegs einschränkend zu verstehen sind, sondern daß vielmehr zahlreiche Abweichungen möglich sind, ohne daß dies den Rahmen der vorliegenden Erfindung sprengt.

So können beispielsweise statt der beschriebenen Spulenformen auch Langdrahtanordnungen, Dipolanordnung und dgl. zur Erzeugung der statischen Magnetfelder oder der elektromagnetischen Wechselfelder vorgesehen werden. Auch sind die genannten Abmessungen und Frequenzbereiche keinesfalls einschränkend zu verstehen, weil z.B. bei einem Übergang auf anderen Kernarten, z.B. Isotope des Kohlenstoffs oder des Fluors andere gyromagnetische Verhältnisse und damit andere Frequenzen bei gleichen Feldstärken erzeugt werden müssen.

Es existieren die folgenden Anmeldungen desselben Anmelders vom selben Tage:
Europäische Patentanmeldung 90 904 230.1 "Verfahren zum Beeinflussen einer Schallquelle, insbesondere eines getauchten Unterseebootes und Unterseeboot"
Europäische Patentanmeldung 90 904 233.5 "Verfahren und Vorrichtung zur Verminderung der Schallemission getauchter Unterseeboote"
Europäische Patentanmeldung 90 904 231.9 "Unterwasserfahrzeug mit einem passiven optischen Beobachtungssystem"
Europäische Patentanmeldung 90 904 238.4 "Verfahren zum Betreiben getauchter Unterseeboote und Unterseeboot"
Europäische Patentanmeldung 90 904 237.6 "Verfahren und Vorrichtung zur Verminderung der Schallemission getauchter Unterseeboote"
Deutsche Patentanmeldung P 39 08 573.2 "Verfahren und Vorrichtung zum Betreiben getauchter Unterseeboote"

## Patentansprüche

1. Verfahren zum Lokalisieren von in wasserhaltiger Umgebung befindlichen protonenarmen Gegenständen, insbesondere zum Orten von Unterseebooten (13) oder Seeminen (61) in einem Meer (11) oder einem Binnengewässer, bei dem eine von dem Gegenstand im Verhältnis zu dessen Umgebung verursachte magnetische Störung unter Ausnutzung von kernmagnetischer Protonenresonanz detektiert wird, dadurch gekennzeichnet, daß in einem Raumbereich des Wassers Bedingungen für das Auftreten einer kernmagnetischen Resonanz von Protonen (51, 53) des Wassers hergestellt werden, daß der Raumbereich hinsichtlich des Auftretens von Resonanzsignalen überwacht wird und daß Verminderungen der Resonanzsignale (45) detektiert werden.

2. Verfahren nach Anspruch 1, dadurch gekennzeichnet, daß die kernmagnetische Resonanz im erdmagnetischen Feld (B₀) durch Einstrahlen eines elektromagnetischen Wechselfeldes (H₁) auf die Protonen (51, 53) erzeugt wird, dessen Frequenz (f_{P}) der Stärke des erdmagnetischen Feldes (B₀) multipliziert mit dem gyromagnetischen Verhältnis von Protonen entspricht.

3. Verfahren nach Anspruch 2, dadurch gekennzeichnet, daß dem erdmagnetischen Feld (B₀) ein statisches Zusatzfeld (B) überlagert wird und daß die Frequenz (f_{P}) des elektromagnetischen Wechselfeldes (H₁) der Stärke des resultierenden Gesamtfeldes (| 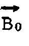 + 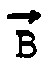 |) multipliziert mit dem gyromagnetischen Verhältnis von Protonen entspricht.

4. Verfahren nach einem oder mehreren der Ansprüche 1 bis 3, dadurch gekennzeichnet, daß das elektromagnetische Wechselfeld (H₁) durch ein Dauerstrichsignal erzeugt wird.

5. Verfahren nach einem oder mehreren der Ansprüche 1 bis 3, dadurch gekennzeichnet, daß das elektromagnetische Wechselfeld (H₁) durch ein getastetes Dauerstrichsignal erzeugt wird, und daß mittels des getasteten Dauerstrichsignals Spin-Echos (76, 78) der Protonen (51, 53) erzeugt werden.

6. Verfahren nach einem oder mehreren der Ansprüche 1 bis 5, dadurch gekennzeichnet, daß der Raumbereich mittels kernspintomographischer Bildgebungsverfahren in näherungsweise punktförmigen Segmenten (90, 93) eines mehrdimensionalen Koordinatenrasters (89, 92) überwacht wird.

7. Verfahren nach Anspruch 3 und 6, dadurch gekennzeichnet, daß die kernmagnetische Resonanz in den Segmenten (90, 93) durch Überlagerung eines Grundfeldes und mindestens eines Gradienten-Zusatzfeldes mit definierter räumlicher Variation der Feldstärke erzeugt wird.

8. Verfahren nach Anspruch 5 und 6, dadurch gekennzeichnet, daß die kernmagnetische Resonanz in den Segmenten (90, 93) durch Einstellen der Feldstärke (H₁) des getasteten Dauerstrichsignals mit definierter räumlicher Variation der Feldstärke (H₁) erzeugt wird.

9. Vorrichtung zum Lokalisieren von in Wasser getauchten protonenarmen Gegenständen, insbesondere zum Orten von Unterseebooten (13) oder Seeminen (61), mit mindestens einer Sendespule (15) zum Anregen einer kernmagnetischen Protonenresonanz mittels eines elektromagnetischen Wechselfeldes (H₁) und mit Empfangsmitteln (37 bis 41) zum Detektieren eines Resonanzsignals (45), dadurch gekennzeichnet, daß die Sendespule (15) so ausgebildet und angeordnet ist, daß ein Raumbereich von mehr als 50 m³, vorzugsweise wesentlich mehr als 1000 m³ des Wassers mit dem elektromagnetischen Wechselfeld (H₁) beaufschlagbar ist und daß die Empfangsmittel (37 bis 41) eine Einheit (40) zum Erkennen einer vorbestimmten Abnahme des Resonanzsignals (45) umfassen.

10. Vorrichtung nach Anspruch 9, dadurch gekennzeichnet, daß die Sendespule (15) in oder über einem Meer (11) oder Binnengewässer angeordnet ist und mit einem mit Sende- und Empfangsmitteln versehenen Luft- oder Wasserfahrzeug in Verbindung steht.

11. Vorrichtung nach Anspruch 10, dadurch gekennzeichnet, daß Mittel zum Schleppen der Sendespule (15) parallel zur Oberfläche oder zum Grund des Meeres (11) oder des Binnengewässers entlang eines vorbestimmten Kurses (s) vorgesehen sind.

12. Vorrichtung nach Anspruch 9, dadurch gekennzeichnet, daß die Sendespule (15d, 15e) stationär in einem Meer (11) oder einem Binnengewässer angeordnet ist und mit stationären Sende- und Empfangsmitteln in Verbindung steht.

13. Vorrichtung nach einem oder mehreren der Ansprüche 9 bis 12, dadurch gekennzeichnet, daß die Sendespule (15e, 15e`) als Resonanzanordnung mit Abmessungen ausgebildet ist, die einem Vielfachen eines Viertels der Wellenlänge (n · λ /4) des elektromagnetischen Wechselfeldes (H₁) entsprechen.

14. Vorrichtung nach einem oder mehreren der Ansprüche 9 bis 13, dadurch gekennzeichnet, daß die Empfangsmittel (37 bis 41) eine von der Sendespule (15a, 15h) getrennte Empfangsspule (15a`, 15h`) aufweisen.

15. Vorrichtung nach Anspruch 14, dadurch gekennzeichnet, daß die Empfangsspule (15a`, 15h`) in unmittelbarer Nähe der Sendespule (15a, 15h) angeordnet ist und sich mit ihrer Spulenfläche im wesentlichen senkrecht zur Spulenfläche der Sendespule (15a, 15h) erstreckt.

16. Vorrichtung nach einem oder mehreren der Ansprüche 9 bis 15, dadurch gekennzeichnet, daß die Sendespule (15) unter einem von 0° verschiedenen Winkel zur Richtung des erdmagnetischen Feldes (B₀) angeordnet ist.

17. Vorrichtung nach einem oder mehreren der Ansprüche 9 bis 16, dadurch gekennzeichnet, daß Feldmittel zum Erzeugen eines magnetischen Gleichfeldes (B) vorgesehen und so ausgebildet und angeordnet sind, daß das Gleichfeld (B) den Raumbereich beaufschlagt.

18. Vorrichtung nach Anspruch 17, dadurch gekennzeichnet, daß die Feldmittel als Gradientenmittel ausgebildet sind und in dem Raumbereich ein Gleichfeld (B) mit definierter räumlicher Variation der Feldstärke erzeugen.

19. Vorrichtung nach einem oder beiden der Ansprüche 17 oder 18, dadurch gekennzeichnet, daß die Feldmittel als Permanentmagnet (67) ausgebildet sind.

20. Vorrichtung nach einem oder mehreren der Ansprüche 9 bis 19, dadurch gekennzeichnet, daß die Spulen (15, 15`, 105) als Gruppe von Einzelspulen (15i₁, 15i₂, 15i₃) ausgebildet. sind, die vorzugsweise unterschiedliche Spulenflächen aufweisen.

21. Vorrichtung nach einem oder mehreren der Ansprüche 9 bis 20, dadurch gekennzeichnet, daß die Spulen (15, 15`, 105) aus einem supraleitenden Draht gewickelt sind.

22. Vorrichtung nach einem oder mehreren der Ansprüche 9 bis 21, dadurch gekennzeichnet, daß die Spulen (15, 15`, 105) eine Spulenfläche von mehr als 10 m², vorzugsweise wesentlich mehr als 100 m² aufweisen.

23. Vorrichtung nach einem oder mehreren der Ansprüche 9 bis 22, dadurch gekennzeichnet, daß die Empfangsmittel Abtastmittel zum lokalisierten Detektieren des Resonanzsignals (45) umfassen.

24. Vorrichtung nach Anspruch 23, dadurch gekennzeichnet, daß die Abtastmittel kernspintomographische Bildgebungsmittel umfassen, die die Erkennung der vorbestimmten Abnahme des Resonanzsignals separat für näherungsweise punktförmige Segmente (90, 93) eines mehrdimensionalen Koordinatenrasters (89, 92) registrieren.

25. Vorrichtung nach einem oder mehreren der Ansprüche 9 bis 24, dadurch gekennzeichnet, daß die Einheit zum Erkennen der vorbestimmten Abnahme des Resonanzsignals (45) so abgestimmt ist, daß eine Alarmanzeige (41) betätigt wird, wenn die Abnahme einem protonenarmen Volumen in dem Raumbereich entspricht, das näherungsweise gleich dem Volumen eines Unterseebootes (13) oder einer Seemine (61) ist.

26. Vorrichtung nach einem oder mehreren der Ansprüche 9 bis 25, dadurch gekennzeichnet, daß das elektromagnetische Wechselfeld eine Frequenz von 1 bis 3 kHz hat.

27. Verwendung des Verfahrens der kernmagnetischen Resonanz von Protonen zum makroskopischen Detektieren von protonenarmen Bereichen in einer protonenreichen Umgebung, insbesondere zum Orten von Unterseebooten (13) oder Seeminen (61) in einem Meer oder einem Binnengewässer.

## Claims

1. A process for locating objects with a low content of protons and contained in an aqueous surrounding, in particular for finding the position of submarines (13) or sea mines (61) in an ocean (11) or an inland water, wherein a magnetic disturbance being caused by the object in relation to its surrounding is detected by means of nuclear magnetic proton resonance, characterized in that conditions are established for the occurrence of a nuclear magnetic resonance of water protons (51, 53) in a volume region of the water, in that the volume region is monitored for the occurrence of resonance signals, and in that a decrease in the resonance signals (45) is detected.

2. The method of claim 1, characterized in that the nuclear magnetic resonance is generated in the earth's magnetic field (B₀) by irradiating the protons (51, 53) with an alternating electromagnetic field (H₁), the frequency of which (f_{P}) corresponding to the strength of the earth's magnetic field (B₀) multiplied by the gyromagnetic ratio of protons.

3. The method of claim 2, characterized in that a static auxiliary field (B) is superimposed on the earth's magnetic field (B₀), and that the frequency (f_{P}) of the alternating electromagnetic field (H₁) corresponds to the strength of the resulting total field (| 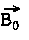 + 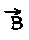 |) multiplied by the gyromagnetic ratio of protons.

4. The method according to one or more of claims 1 - 3, characterized in that the alternating electromagnetic field (H₁) is generated by a CW signal.

5. The method according to one or more of claims 1 - 3, characterized in that the alternating electromagnetic field (H₁) is generated by a gated CW signal and that spin-echos (76, 78) of the protons (51, 53) are generated by means of the gated CW signals.

6. The method according to one or more of claims 1 - 5, characterized in that the volume region is monitored by means of nuclear spin tomographical imaging methods in approximately point-shaped segments (90, 93) of a multidimensional grid of coordinates (89, 92).

7. The method of claims 3 and 6, characterized in that the nuclear magnetic resonance in the segments (90, 93) is generated by superimposing upon a main field at least one additional gradient field of a predetermined spatial variation in field strength.

8. The method of claims 5 and 6, characterized in that the nuclear magnetic resonance in the segments (90, 93) is generated by adjusting the field strength (H₁) of the gated CW signal by a predetermined spatial variation of the field strength (H₁).

9. An apparatus for locating objects with a low content of protons and contained in an aqueous surrounding, in particular for finding the position of submarines (13) or sea mines (61), comprising at least one transmitter coil (15) for exciting a nuclear magnetic proton resonance by means of an alternating electromagnetic field (H₁), and comprising receiver means (37 - 41) for detecting a resonance signal (45), characterized in that the transmitter coil (15) is configured and arranged such that a volume region of the water of more than 50 m³, preferably essentially more than 1,000 m³ of the water are subjected to the alternating electromagnetic field (H₁) and that the receiver means (37 - 41) comprise a unit (40) for detecting a predetermined decrease of the resonance signal (45).

10. The apparatus of claim 9, characterized in that the transmitter coil (15) is arranged in or above an ocean (11) or an inland water and is connected with an air vehicle or a water vehicle carrying transmitter and receiver means.

11. The apparatus of claim 10, characterized in that means are provided for towing the transmission coil (15) parallel to the surface of the sea (11) or the inland water along a predetermined course (s).

12. The apparatus of claim 9, characterized in that the transmitter coil (15d, 15e) is arranged stationary in an ocean (11) or an inland water and is connected with stationary transmitter and receiver means.

13. The apparatus according to one or more of claims 9 - 12, characterized in that the transmitter coil (15e, 15e') is configured as a resonance arrangement with dimensions corresponding to multiples of a quarter wavelength (n · λ/4) of the alternating electromagnetic field (H₁).

14. The apparatus according to one or more of claims 9 - 13, characterized in that the receiving means (37 - 41) comprise a receiver coil (15a', 15h'), separate from the transmitter coil (15a, 15h).

15. The apparatus of claim 14, characterized in that the receiver coil (15a', 15h') is arranged in direct vicinity of the transmitter coil (15a, 15h) and has a coil plane extending essentially perpendicular to the coil plane of the transmitter coil (15a, 15h).

16. The apparatus according to one or more of claims 9 - 15, characterized in that the transmitter coil (15) is arranged under an angle other than 0° relative to the direction of the earth's magnetic field (B₀).

17. The apparatus according to one or more of claims 9 - 16, characterized in that field means are provided for generating a constant magnetic field (B) and being configured and arranged such that the volume region is subjected to the constant magnetic field (B).

18. The apparatus of claim 17, characterized in that the field means are configured as gradient means generating within the volume region a constant field (B) having a predetermined spatial variation of the field strength.

19. The apparatus according to one or both of claims 17 or 18, characterized in that the field means are configured as a permanent magnet (67).

20. The apparatus according to one or more of claims 9 - 19, characterized in that the coils (15, 15', 105) are configured as a group of individual coils (15i₁, 15i₂, 15i₃) having, preferably, differing coil areas.

21. The apparatus according to one or more of claims 9 - 20, characterized in that the coils (15, 15', 105) are wound from a superconducting wire.

22. The apparatus according to one or more of claims 9 - 21, characterized in that the coils (15, 15', 105) have a coil area of more than 10 m², preferably essentially more than 100 m².

23. The apparatus according to one or more of claims 9 - 22, characterized in that the receiver means comprise scanning means for a localized detection of the resonance signals (45).

24. The apparatus of claim 23, characterized in that the scanning means comprise nuclear spin tomographic imaging means recording recognition of the predetermined decrease in the resonance signal for approximately point-shaped segments (90, 93) of a multi-dimensional grid of coordinates (89, 92).

25. The apparatus according to one or more of claims 9 - 24, characterized in that the unit for detecting the predetermined decrease of the resonance signal (45) is tuned such that an alarm indicator (41) is activated when the decrease of a volume with a low content of protons corresponds to the spatial area being approximately equal to the volume of a submarine (13) or a sea mine (61).

26. The apparatus according to one or more of claims 9 - 25, characterized in that the alternating electromagnetic field has a frequency of between 1 and 3 kHz.

27. Use of a method of nuclear magnetic resonance of protons for macroscopically detecting areas with a low content of protons in a surrounding with a high content of protons, in particular for finding the positions of submarines (13) or sea mines (61) in an ocean or an inland water.

## Revendications

1. Procédé de localisation d'objets faiblement protoniques, se trouvant dans un environnement aqueux, en particulier de localisation de sous-marins (13) ou de mines marines (61) dans la mer (11) ou des eaux intérieures, dans lequel une perturbation magnétique, causée par l'objet par rapport à son milieu ambiant, est détectée par exploitation de la résonance protonique nucléaire, caractérisé en ce que dans une zone spatiale de l'eau, il est créé des conditions pour l'apparition d'une résonance magnétique nucléaire des protons (51, 53) de l'eau, en ce que l'apparition de signaux de résonance est contrôlée dans cette zone et en ce que des diminutions des signaux de résonance (45) sont détectées.

2. Procédé selon la revendication 1, caractérisé en ce que la résonance magnétique nucléaire dans le champ magnétique terrestre (Bₒ) est produite par envoi d'un champ alternatif électromagnétique (H₁) sur les protons (51, 53), dont la fréquence (f_{P}) correspond à l'intensité du champ magnétique terrestre (Bₒ) multipliée par le rapport gyromagnétique des protons.

3. Procédé selon la revendication 2, caractérisé en ce qu'au champ magnétique terrestre (Bₒ) est superposé un champ supplémentaire statique (B) et en ce que la fréquence (f_{P}) du champ alternatif électromagnétique (H₁) correspond à l'intensité du champ total résultant (| 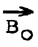 + 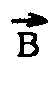 |) multipliée par le rapport gyromagnétique des protons.

4. Procédé selon une ou plusieurs des revendications 1 à 3, caractérisé en ce que le champ alternatif électromagnétique (H₁) est produit par un signal à ondes entretenues.

5. Procédé selon une ou plusieurs des revendications 1 à 3, caractérisé en ce que le champ alternatif électromagnétique (H₁) est produit par un signal à ondes entretenues pulsé et en ce que des échos de spin (76, 78) des protons (51, 53) sont produits, au moyen du signal à ondes entretenues pulsé.

6. Procédé selon une ou plusieurs des revendications 1 à 5, caractérisé en ce que la zone spatiale est contrôlée au moyen de procédés de production d'images tomographiques de spin nucléaire, en des segments (90, 93), approximativement ponctuels d'une grille de coordonnées (89, 92) multidimensionnelle.

7. Procédé selon les revendications 3 et 6, caractérisé en ce que la résonance magnétique nucléaire dans les segments (90, 93) est produite par superposition d'un champ de base et d'au moins un champ supplémentaire à gradient avec variation spatiale définie de l'intensité du champ.

8. Procédé selon les revendications 5 et 6, caractérisé en ce que la résonance magnétique nucléaire dans les segments (90, 93) est produite par réglage de l'intensité de champ (H₁) du signal à ondes entretenues pulsé, avec variation spatiale définie de l'intensité de champ (H₁).

9. Dispositif de localisation d'objets faiblement protoniques, immergés dans l'eau, en particulier de localisation de sous-marins (13) ou de mines marines (61), comportant au moins une bobine d'émission (15) destinée à susciter une résonance magnétique nucléaire de protons au moyen d'un champ alternatif électromagnétique (H₁) et comportant des moyens de réception (37 à 41) destinés à détecter un signal de résonance (45), caractérisé en ce que la bobine d'émission (15) est conçue et montée de manière qu'une zone de plus de 50 m³, de préférence sensiblement supérieure à 1 000 m³ d'eau, reçoive le champ alternatif électromagnétique (H₁) et en ce que les moyens de réception (37 à 41) comportent une unité (40) en vue de la détection d'une diminution prédéterminée du signal de résonance (45).

10. Dispositif selon la revendication 9, caractérisé en ce que la bobine d'émission (15) est placée dans ou au-dessus de la mer (11) ou d'eaux intérieures et est en liaison avec un aéronef ou une embarcation, équipé de moyens d'émission et de réception.

11. Dispositif selon la revendication 10, caractérisé en ce qu'il est prévu des moyens de remorquage de la bobine d'émission (15) parallèlement à la surface ou au fond de la mer (11) ou des eaux intérieures, le long d'une route (s) prédéterminée.

12. Dispositif selon la revendication 9, caractérisé en ce que la bobine d'émission (15d, 15e) est fixe dans la mer (11) ou dans des eaux intérieures et est reliée à des moyens fixes d'émission et de réception.

13. Dispositif selon une ou plusieurs des revendications 9 à 12, caractérisé en ce que la bobine d'émission (15e, 15e') est conçue sous la forme d'un dispositif à résonance dont les dimensions correspondent à un multiple du quart de la longueur d'onde (n . λ/4) du champ alternatif électromagnétique (H₁).

14. Dispositif selon une ou plusieurs des revendications 9 à 13, caractérisé en ce que les moyens de réception (37 à 41) comportent une bobine de réception (15a', 15h'), séparée de la bobine d'émission (15a, 15h).

15. Dispositif selon la revendication 14, caractérisé en ce que la bobine de réception (15a', 15h') est placée à proximité immédiate de la bobine d'émission (15a, 15h) et sa surface est sensiblement perpendiculaire à la surface de la bobine d'émission (15a, 15h).

16. Dispositif selon une ou plusieurs des revendications 9 à 15, caractérisé en ce que la bobine d'émission (15) forme un angle différent de 0° par rapport à la direction du champ magnétique terrestre (Bₒ).

17. Dispositif selon une ou plusieurs des revendications 9 à 16, caractérisé en ce que des moyens à champ sont prévus pour produire un champ continu magnétique (B) et sont conçus et disposés de manière que le champ continu (B) concerne le domaine spatial.

18. Dispositif selon la revendication 17, caractérisé en ce que les moyens à champ sont conçus sous la forme de moyens à gradient et produisent dans le domaine spatial un champ continu (B) avec variation spatiale définie de l'intensité du champ.

19. Dispositif selon une ou les deux revendications 17 et 18, caractérisé en ce que les moyens à champ sont conçus sous la forme d'aimant permanent (67).

20. Dispositif selon une ou plusieurs des revendications 9 à 19, caractérisé en ce que les bobines (15, 15', 105) sont conçues sous la forme d'un groupe de bobines individuelles (15i₁, 15i₁, 15i₂, 15i₃) qui présentent de préférence des surfaces de bobine différentes.

21. Dispositif selon une ou plusieurs des revendications 9 à 20, caractérisé en ce que les bobines (15, 15', 105) sont constituées d'un fil supraconducteur enroulé.

22. Dispositif selon une ou plusieurs des revendications 9 à 21, caractérisé en ce que les bobines (15, 15', 105) présentent une surface supérieure à 10 m², de préférence sensiblement supérieure à 100 m².

23. Dispositif selon une ou plusieurs des revendications 9 à 22, caractérisé en ce que les moyens de réception comportent des moyens de balayage pour la détection localisée du signal de résonance (45).

24. Dispositif selon la revendication 23, caractérisé en ce que les moyens de balayage comportent des moyens de formation d'images tomographiques à spin nucléaire qui enregistrent la détection de la diminution prédéterminée du signal de résonance, séparément pour des segments (90, 93) approximativement ponctuels d'une grille de coordonnées (89, 92) multidimensionnelle.

25. Dispositif selon une ou plusieurs des revendications 9 à 24, caractérisé en ce que l'unité destinée à détecter la diminution prédéterminée du signal de résonance (45) est réglée de manière qu'une indication d'alarme (41) soit actionnée lorsque la diminution correspond à un volume faiblement protonique dans la zone spatiale, qui est à peu près égal au volume d'un sous-marin (13) ou d'une mine marine (61).

26. Dispositif selon une ou plusieurs des revendications 9 à 25, caractérisé en ce que le champ alternatif électromagnétique présente une fréquence comprise entre 1 et 3 kHz.

27. Mise en oeuvre du procédé de résonance magnétique nucléaire de protons en vue de la détection macroscopique de zones faiblement protoniques dans un environnement riche en protons, en particulier pour la localisation de sous-marins (13) ou de mines marines (61) en mer ou dans des eaux intérieures.
